# EUROPEAN PATENT APPLICATION

(11) **EP 2 876 679 A2**
(43) Date of publication of application: **27.05.2015**
(21) Application number: 14187829.8
(22) Date of filing: 06.10.2014
(51) Int. Cl.: H01L 23/485, H01L 21/66, H01L 23/58, H01L 23/00

(54) **Semiconductor device and method for manufacturing the same**

(30) Priority: 30.10.2013 JP 2013224962
(71) Applicant: Renesas Electronics Corporation, Kanagawa 211-8668 (JP)
(72) Inventor: Ishii, Yasushi, Kawasaki-shi,, Kanagawa 211-8668, (JP); Adachi, Tetsuo, Kawasaki-shi,, Kanagawa 211-8668, (JP)
(74) Representative: Calderbank, Thomas Roger

(57) **Abstract**

This invention provides a semiconductor device with improved reliability. The semiconductor device (CHP1) comprising:a semiconductor substrate (SS) having an element formation surface;a first insulating film (PVL) that has a first surface (PVb) facing the semiconductor substrate (SS), a second surface (PVt) opposite to the first surface (PVb), and a plurality of openings (PVk) passing therethrough from one of the first surface (PVb) and the second surface (PVt) to the other in the thickness direction, and is formed so as to cover the element formation surface of the semiconductor substrate (SS); anda plurality of electrode pads (PD1, PD2, PD3) that are formed between the first insulating film (PVL) and the semiconductor substrate (SS), and are exposed from the first insulating film (PVL) at positions overlapping the openings (PVk) in the first insulating film (PVL),wherein, the electrode pads include:a plurality of the first-line electrode pads (PD1) formed in a first line along a first chip side (Cs1) of a perimeter of the second surface in plan view;a plurality of second-line electrode pads (PD2) formed in a second line along the first chip side (Cs1), the second line located further than the first line from the first chip side (Cs1) in plan view; anda plurality of third-line electrode pads (PD3) formed in a third line along the first chip side (Cs1), the third line located further than the second line from the first chip side (Cs1) in plan view, and wherein, the areas of the respective first-line electrode pads (PD1) are smaller than the areas of the respective second-line electrode pads (PD2) and the respective third-line electrode pads (PD3).

## Description

The disclosure of Japanese Patent Application No. 2013-224962 filed on October 30, 2013 including the specification, drawings and abstract is incorporated herein by reference in its entirety.

This invention relates to semiconductor device technology, and, for example, relates to the layout of electrode pads of semiconductor chips.

Japanese Unexamined Patent Application Publication Nos. 2003-197748 and 2000-164620 disclose semiconductor devices with bonding pads formed in a plurality of lines over a surface where electrodes are to be formed.

Japanese Unexamined Patent Application Publication No. 2000-164620 discloses electrode pads having an electrode region for bonding and an electrode region for inspection.

In addition, Japanese Unexamined Patent Application Publication No. Hei 5(1993)-206383 discloses a method for manufacturing a semiconductor device in which electrode pads are electrically coupled to testing pads and the testing pads are placed in a region sandwiched between dicing lines formed along the perimeter of the IC.

Electrode pads, which are external terminals of a semiconductor device (semiconductor chip), are used as an interface for electrically coupling the semiconductor device and an external device. For instance, in order to make the semiconductor device operable, conductive members, such as wires, are bonded to electrode pads to electrically couple the semiconductor device to an external device through the conductive members. In another instance, in order to conduct an electrical inspection on a circuit formed on a semiconductor device, an electrical inspection terminal is brought into contact with electrode pads to conduct the electrical inspection.

The inventors of this application have studied how to reduce the plane size of the electrode pads as part of further miniaturization of the semiconductor device. Specifically, the inventors focused on the point that the required minimum plane size of the electrode pads differs according to the applications of the electrode pads and found out a method for effectively arranging a great number of the electrode pads by using electrode pads with different plane sizes for different applications.

However, the inventors also found that just simple arrangement of the electrode pads with different plane sizes still leaves problems in reliability.

The other problems and novel features of the present invention will become apparent from the following description in the present specification and the accompanying drawings.

The semiconductor device according to an embodiment has a plurality of electrode pads arranged in a plurality of lines extending along a first chip side of a perimeter of the semiconductor device in plan view. In addition, among the electrode pads, the areas of a plurality of first-line electrode pads arranged near the first chip side are smaller than the areas of a plurality of second-line electrode pads arranged in a line located further than the first-line electrode pads from the first chip side.

According to the aforementioned embodiment, the semiconductor device can have improved reliability.

In the drawings:
FIG. 1 is a cross-sectional view showing a configuration example of a semiconductor package in which a semiconductor chip according to an embodiment is mounted.
FIG. 2 is a plan view of a circuit formation surface of the semiconductor chip in FIG. 1.
Fig. 3 is an enlarged plan view of part A in FIG. 2.
Fig. 4 is an enlarged cross-sectional view taken along line A-A in FIG. 3.
Fig. 5 is an enlarged cross-sectional view of part A in FIG. 4.
FIG. 6 is an enlarged cross-sectional view of a relevant part showing the state in which a wire is attached to an electrode pad of the semiconductor chip.
FIG. 7 is an enlarged plan view of the relevant part in FIG. 6.
FIG. 8 is an enlarged cross-sectional view of a relevant part showing the state in which an electrical testing terminal is in contact with the electrode pad of the semiconductor chip.
FIG. 9 is an enlarged plan view of a relevant part, corresponding to a plane in FIG. 8, showing an example of a probe mark imprinted after a scribing operation by a probe needle.
FIG. 10 is an explanatory schematic diagram showing, in plan view, directions of force produced when the temperature of the semiconductor package in FIG. 1 changes.
FIG. 11 is an explanatory schematic diagram showing, in cross-sectional view, directions of force produced when the temperature of the semiconductor package in FIG. 1 changes.
FIG. 12 is a schematic enlarged cross-sectional view of the force shown in FIGS. 10 and 11 applied onto an electrode pad.
FIG. 13 is a schematic enlarged cross-sectional view showing the state in which the electrode pad is deformed and cracked by the force shown in FIG. 12.
Fig. 14 is an enlarged plan view of part B in FIG. 2.
FIG. 15 is an enlarged plan view of an electrode pad formed at an end of the second line, on a further enlarged scale, among the electrode pads shown in FIG. 14.
FIG. 16 is an explanatory diagram showing main process flow for manufacturing the semiconductor chip shown in FIGS. 2 to 5.
FIG. 17 is an enlarged cross-sectional view showing the state in which a plurality of semiconductor elements are formed over an element formation surface of a semiconductor substrate in a semiconductor element formation process in FIG. 16.
FIG. 18 is an enlarged cross-sectional view showing the state in which a plurality of wiring layers are stacked over the element formation surface of the semiconductor substrate in FIG. 17.
FIG. 19 is an enlarged cross-sectional view showing the state in which a plurality of electrode pads are formed over the uppermost wiring layer in FIG. 18.
FIG. 20 is an enlarged cross-sectional view showing the state in which a protective film is formed so as to cover the uppermost wiring layer in FIG. 19.
FIG. 21 is an enlarged cross-sectional view showing the state in which a plurality of openings are formed in the protective film in FIG. 20.
FIG. 22 is a plan view of a modification, corresponding to FIG. 2.
FIG. 23 is an enlarged plan view of the modification, corresponding to FIG. 3.
FIG. 24 is an enlarged plan view of a part of the electrode pads in FIG. 23 on a further enlarged scale.
FIG. 25 is an enlarged plan view of another modification, corresponding to FIG. 3.
FIG. 26 is an enlarged plan view of electrode pads formed at ends of the lines along which the electrode pads shown in FIG. 25 are arranged.
FIG. 27 is an enlarged plan view of the modification, corresponding to FIG. 26.
FIG. 28 is an enlarged plan view of the modification, corresponding to FIG. 14.
FIG. 29 is an enlarged plan view of yet another modification, corresponding to FIG. 14.
FIG. 30 is an enlarged plan view of a comparative example, corresponding to FIG. 3.
FIG. 31 is an enlarged plan view of another comparative example, corresponding to FIG. 3.

### (Explanation of DescriptionManner, Basic Terms, and Usage in the Present Application)

In the present application, a description in embodiments may be made after being divided in a plurality of sections if necessary for convenience's sake. These sections are not independent from each other, but, irrespective of the order of the sections, they may each be a part of a single example, or one of them may be a partial detail of the other or a modification of a part or whole of the other one, unless otherwise specifically indicated. In principle, a description on a portion similar to that described before is not repeated. Moreover, constituent elements in the embodiments are not essential unless otherwise specifically indicated, limited to the number theoretically, or principally apparent from the context that they are essential.

Similarly in the description of the embodiments, with regard to any material, any composition or the like, the term "X made of A" or the like does not exclude X having an element other than A unless otherwise specifically indicated or principally apparent from the context that it is not. For example, with regard to a component A, the term "X made of A" means that "X has A as a main component thereof". It is needless to say that, for example, the term "silicon member" is not limited to a member made of pure silicon but also means a member made of a SiGe (silicon-germanium) alloy or another multi-element alloy having silicon as a main component or a member containing another additive. In addition, even when gold plating, Cu layer, nickel plating, and others are described, they include not only pure materials but also is a member mainly containing gold, Cu, nickel, and others, unless otherwise stated or except in the case where they are apparently not so.

When a reference is made to a specific number or amount, the number or amount may be greater than or less than the specific number or amount unless otherwise specifically indicated, limited to the specific number or amount theoretically, or apparent from the context that it is not.

Moreover, the same or similar components are denoted by the same or similar reference symbols or reference numerals throughout each drawing of the embodiments, and the description thereof will not be reiterated in principle.

In the accompanying drawings, hatching or the like is sometimes omitted even from a portion in cross-section when hatching or the like makes the drawing cumbersome and complicated or when the portion is apparently distinct from hollow spaces. In relation thereto, an outline of background may be sometimes omitted even in a closed hole in plan view in some cases such that it is apparent from the explanations or others. Further, even not in the cross-sectional surface, hatching or a dotted pattern may be added in order to clarify that it is not the hollow spaces or to clearly indicate the boundary.

Furthermore, this application may sometimes use the terms, an upper surface or a lower surface; however, since there are various embodiments for the semiconductor device, in some cases, packaged semiconductor devices may have the upper surface positioned lower than the lower surface, for example. In this application, the plane of a semiconductor chip on which elements are formed is referred to as an upper surface or a main surface, while the surface opposite to the upper surface is referred to as a lower surface or back surface.

The semiconductor device described in this application includes a semiconductor chip obtained by forming integrated circuits including semiconductor elements over a semiconductor substrate and then cutting the semiconductor substrate into individual pieces, and also includes a semiconductor package obtained by mounting the semiconductor chip over a lead frame or an interposer. In the following embodiment, the terms, the semiconductor chip and semiconductor package, are distinctively used to make clear the difference between them.

### <Semiconductor package (semiconductor device)>

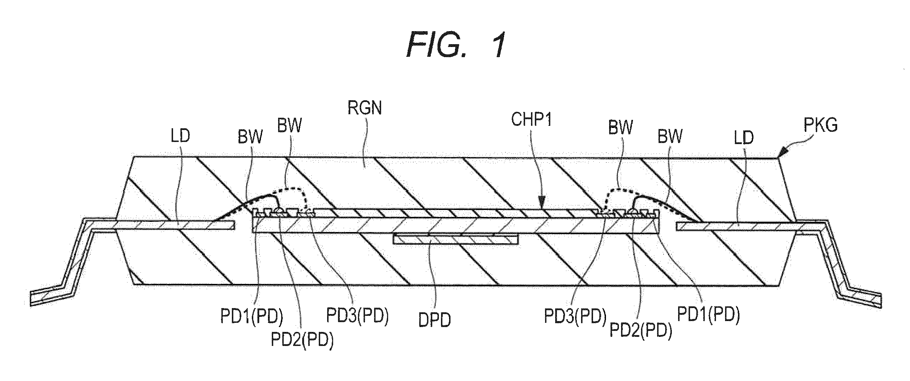

Firstly, a description will be made about the configuration of a semiconductor package with a semiconductor chip mounted therein as an example of an embodiment of the semiconductor chip. FIG. 1 is a cross-sectional view showing a configuration example of a semiconductor package in which a semiconductor chip is mounted according to the embodiment. For the purpose of explicitly indicating that a semiconductor chip CHP1 has a plurality of electrode pads PD coupled to wires BW and not coupled to the wires BW, the wires BW formed in a different cross-section from FIG. 1 are indicated by dotted lines.

As shown in FIG. 1, the semiconductor package (semiconductor device) PKG according to this embodiment contains a semiconductor chip CHP1 having a plurality of electrode pads PD. The semiconductor chip CHP1 is adhesively fixed over a die pad (a chip mount) DPD which is used to mount a chip thereon. Around the semiconductor chip CHP1, a plurality of leads (external terminals) LD, which are external terminals of the semiconductor package PKG, are arranged.

Some of the electrode pads PD over the semiconductor chip CHP1 are electrically coupled to the leads LD through the wires (conductive members) BW. Specifically, one end of a wire BW is bonded to an electrode pad PD and the other end of the wire BW is bonded to a lead LD. The wires BW are metal wires mainly containing, for example, gold (Au) or copper (Cu). The electrode pads PD are metal films mainly containing, for example, aluminum. The main metal material of the electrode pads PD and the main metal material of the wires BW form an alloy layer at the bonded interfaces between the wires BW and electrode pads PD.

The bonding parts between the wires BW and electrode pads PD are sealed with a resin body RGN. In the example shown in FIG. 1, the wires BW, semiconductor chip CHP1, die pad DPD, and a part of each lead LD are sealed with the resin body RGN. The resin body RGN is a composition containing, for example, a resin material and a plurality of filler particles. The resin material contained in the resin body RGN may be, for example, thermosetting resin, such as epoxy resin. The filler particles contained in the resin body RGN may be, for example, inorganic particles, such as silica (SiO₂).

As a configuration example of a semiconductor package PKG with the bonding parts between the semiconductor chip CHP1 and wires BW sealed with the resin body RGN, FIG. 1 shows a so-called lead-frame type semiconductor package PKG; however, there are various modifications of the semiconductor package PKG. For instance, in an embodiment, a semiconductor chip is mounted on a wiring board (not shown) that is used as an interposer.

### <Semiconductor chip (semiconductor device)>

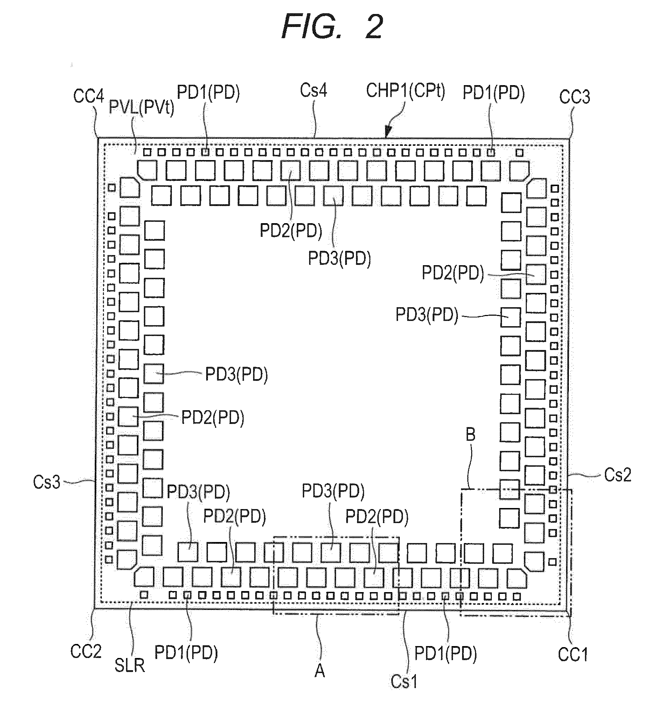

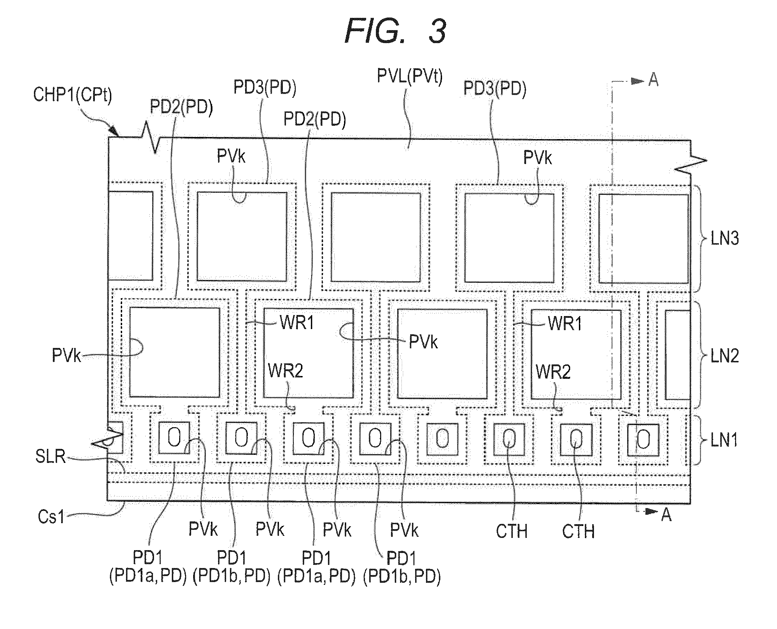

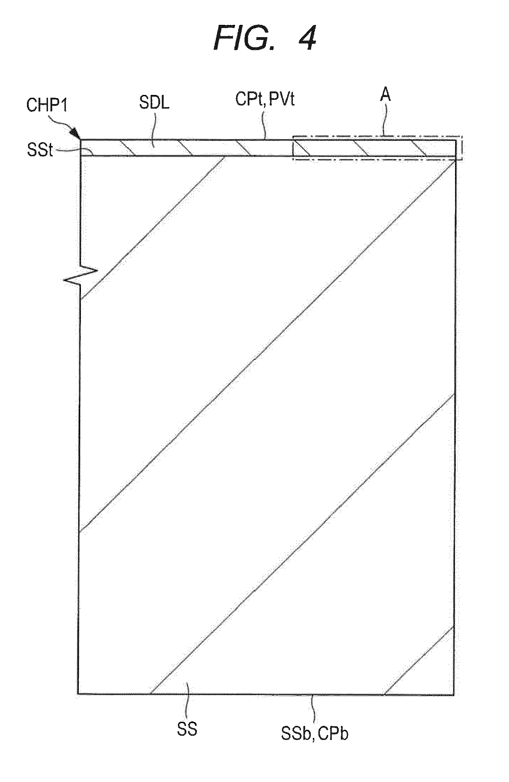

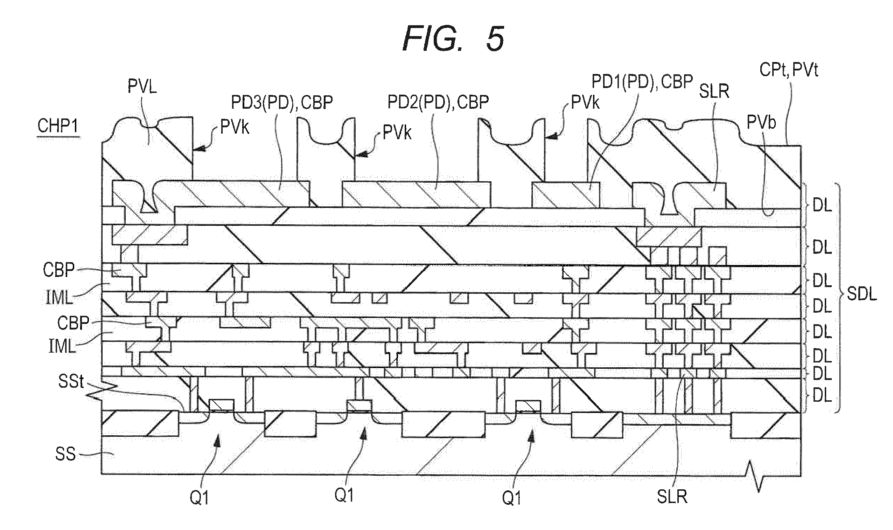

Next, the configuration of the semiconductor chip shown in FIG. 1 will be described. FIG. 2 is a plan view of a circuit formation surface of the semiconductor chip in FIG. 1. FIG. 3 is an enlarged plan view of part A in FIG. 2. FIG. 4 is an enlarged cross-sectional view taken along line A-A in FIG. 3. FIG. 5 is an enlarged cross-sectional view of part A in FIG. 4.

FIG. 5 shows a wiring section SDL made by stacking eight wiring layers DL including a wiring layer DL over which the electrode pads PD are formed, just as an example. The number of the stacked wiring layers DL is not limited to eight, but can be, for example, seven or fewer or nine or more in various modifications. FIG. 5 also shows a MOSFET (Metal Oxide Semiconductor Field Effect Transistor) structure as an example of a plurality of semiconductor elements Q1 formed over an upper surface SSt of a semiconductor substrate SS. However, there are many other structural modifications of the semiconductor elements Q1 in addition to the MOSFET.

As shown in FIG. 4, the semiconductor chip CHP1 includes a semiconductor substrate SS having an upper surface (semiconductor element formation surface) SSt where a plurality of semiconductor elements Q1 (see FIG. 5) are formed and a lower surface (back surface) SSb opposite to the upper surface SSt. The semiconductor substrate SS is a base material of the semiconductor chip CHP1 and is made of, for example, silicon (Si) as a main component. In addition, the semiconductor chip CHP1 includes a wiring section SDL formed over the upper surface SSt of the semiconductor substrate SS.

In the example shown in FIG. 4, the semiconductor chip CHP1 has a lower surface (back surface) CPb that is identical to the lower surface SSb of the semiconductor substrate SS. In addition, the semiconductor chip CHP1 has an upper surface (front surface, main surface) CPt that is composed of an upper surface PVt of a protective film PVL formed so as to cover the uppermost layer of the wiring section SDL (see FIG. 5) and surfaces of the electrode pads PD exposed from the protective film PVL (see FIG. 5).

The wiring section SDL includes the plurality of wiring layers DL stacked on top of each other as illustrated on an enlarged scale in FIG. 5. In the wiring section SDL, the semiconductor elements Q1 and the electrode pads PD are electrically coupled to one another through the stacked wiring layers DL. The electrode pads PD are formed over the uppermost wiring layer (which is a layer located furthest from the upper surface SSt of the semiconductor substrate SS) among the wiring layers DL in the wiring section SDL.

Each of the wiring layers DL has an insulating layer IML deposited over the semiconductor substrate SS and a plurality of conductive patterns (lines) CBP embedded in openings formed in the insulating layer IML. In the wiring section SDL, electrically coupling the conductive patterns CBP in the wiring layers DL to one another forms conductive paths that electrically couple the semiconductor elements Q1 and electrode pads PD.

The materials making up the wiring layers DL are not specifically limited to the following materials, but can be shown below as an example. The insulating layers IML contain, for example, silicon dioxide (SiO₂) as a main component. The wiring layers DL contain, for example, copper (Cu) as a main component.

The uppermost wiring layer DL including the electrode pads PD is covered with a protective film (passivation film, insulating film) PVL. The protective film PVL is provided so as to cover the wiring section SDL to protect the wiring section SDL. The protective film PVL, which is configured to cover the wiring section SDL, has a lower surface (surface) PVb facing the upper surface SSt of the semiconductor substrate SS and an upper surface (surface) PVt opposite to the lower surface PVb.

Since the protective film PVL is configured to cover the wiring section SDL as shown in FIG. 5, the wiring section SDL formed with the plurality of wiring layers DL stacked on top of one another is interposed between the lower surface PVb of the protective film PVL and the upper surface SSt of the semiconductor substrate SS. The lower surface PVb of the protective film PVL is in intimate contact with the uppermost wiring layer DL among the wiring layers DL.

The protective film PVL is made of, for example, silicon dioxide (SiO₂) or silicon nitride (SiN) or a laminated film of both materials. In addition, a resin film, such as a polyimide film, may be occasionally formed so as to further cover the film of silicon dioxide or silicon nitride. The protective film PVL shown in FIG. 5 is a single-layered insulating film as the simplest example; however, the protective film PVL may be a layered film in a modification. In the case where the protective film PVL is a layered insulating film, the lower surface of the lowermost layer (a layer closest to the wiring layers DL) of the insulating film corresponds to the lower surface PVb of the protective film PVL. Also, in the case where the protective film PVL is a layered insulating film, the upper surface of the uppermost layer (a layer furthest from the wiring layers DL) of the insulating film corresponds to the upper surface PVt of the protective film PVL.

As shown in FIG. 2, the upper surface CPt of the semiconductor chip CHP1 is quadrilateral in plan view. In other words, the perimeter of the upper surface CPt of the semiconductor chip CHP1 includes a side (chip side) Cs1, a side (chip side) Cs2 intersecting the side Cs1, a side (chip side) Cs3 opposite to the side Cs2 and intersecting the side Cs1, and a side (chip side) Cs4 opposite to the side Cs1 and intersecting the side Cs2 and side Cs3. In addition, the perimeter of the upper surface CPt of the semiconductor chip CHP1 includes a corner CC1 which is an intersection point of the side Cs1 and side Cs2, a corner CC2 which is an intersection point of the side Cs1 and side Cs3, a corner CC3 which is an intersection point of the side Cs2 and side Cs4, and a corner CC4 which is an intersection point of the side Cs3 and side Cs4.

The electrode pads PD of the semiconductor chip CHP1 are formed between the protective film PVL and semiconductor substrate SS as shown in FIG. 5 and are exposed from the protective film PVL over the upper surface CPt of the semiconductor chip CHP1 as shown in FIG. 3. Specifically, as shown in FIGS. 3 and 5, a plurality of openings PVk are formed in the protective film PVL so as to overlap the respective electrode pads PD in the thickness direction. Each of the openings PVk is formed so as to pass through the protective film PVL from one of the upper surface PVt and lower surface PVb to the other (see FIG. 5). Thus, the electrode pads PD are exposed from the protective film PVL at positions overlapping the openings PVk formed in the protective film PVL. The openings PVk allow the respective electrode pads PD to couple with the conductive members, such as wires BW, as shown in FIG. 1. In other words, the electrode pads PD can be utilized as external terminals of the semiconductor chip CHP1.

In this embodiment, as shown in FIG. 3, the electrode pads PD are formed in a plurality of lines (three lines in the example of FIG. 3) in plan view. Specifically, the electrode pads PD include a plurality of electrode pads (first-line electrode pads) PD1 formed in a first line LN1 along the side Cs1 of the perimeter of the upper surface PVt of the protective film PVL in plan view. The electrode pads PD also include a plurality of electrode pads (second-line electrode pads) PD2 formed in a second line LN2 along the side Cs1, but further than the first line LN1 from the side Cs1 in plan view. The electrode pads PD also include a plurality of electrode pads (third-line electrode pads) PD3 formed in a third line LN3 along the side Cs1, but further than the second line LN2 from the side Cs1 in plan view.

FIG. 3 shows an electrode pad group arranged along the side Cs1 in an enlarged scale as a representative example of the electrode pads; however, the electrode pad group is arranged along the side Cs2, side Cs3, and side Cs4 in the same manner as shown in the example of FIG. 2.

Forming the electrode pads PD in the plurality of lines as described in this embodiment can increase the number of the electrode pads PD available on a single semiconductor chip CHP1. In addition, collectively placing the electrode pads PD near the perimeter in plan view can mitigate the impact caused by wire bonding or the like on a core circuit formed at the center of the semiconductor chip.

In this embodiment as shown in FIG. 3, a seal ring (metal pattern) SLR is placed between the side Cs1 of the perimeter of the semiconductor chip CHP1 and the electrode pads PD so as to extend along the side Cs1 in plan view. As shown in FIG. 2, the seal ring SLR is formed along the perimeter of the semiconductor chip CHP1 in plan view, and the electrode pads PD are formed in an area enclosed by the seal ring SLR. As shown in FIG. 5, the seal ring SLR is a metal pattern made of the same material as that of the conductive patterns CBP formed in the respective wiring layers DL of the wiring section SDL. The seal ring SLR is formed so as to pass through the wiring layers DL from the wiring layer DL in which the electrode pads PD are formed to the upper surface SSt of the semiconductor substrate SS. The uppermost wiring layer DL is made of the same metal material as the electrode pads PD, for example, a metal material mainly containing aluminum.

Providing the seal ring SLR along the outer edge of the semiconductor chip CHP1 in plan view can protect the area enclosed by the seal ring SLR. For instance, the seal ring SLR can block water from entering the area enclosed by the seal ring SLR from the side surfaces of the semiconductor chip CHP1. Also, even if the insulating layer IML of the wiring section SDL is exfoliated or cracked at the side surfaces of the semiconductor chip CHP1, the seal ring SLR can impede the progress of the exfoliation or cracks toward the enclosed area.

### <Studies on plane size reduction of semiconductor chip>

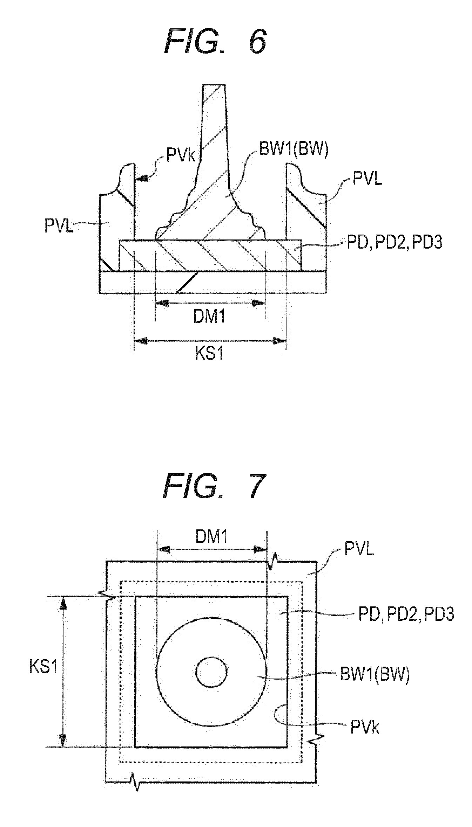

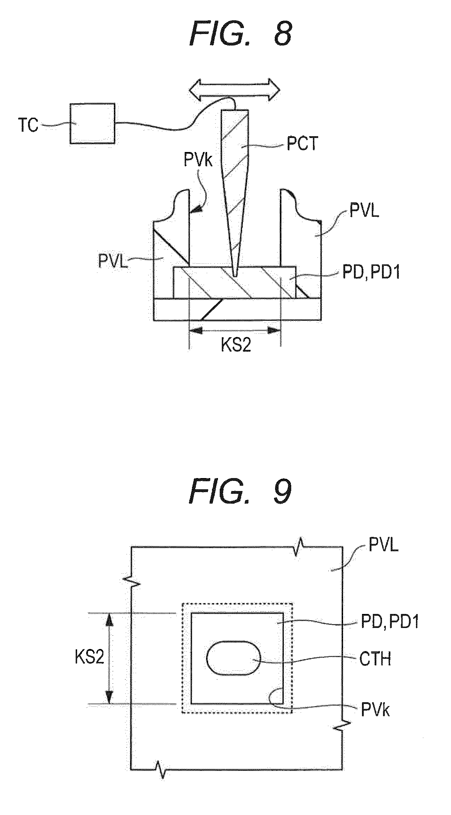

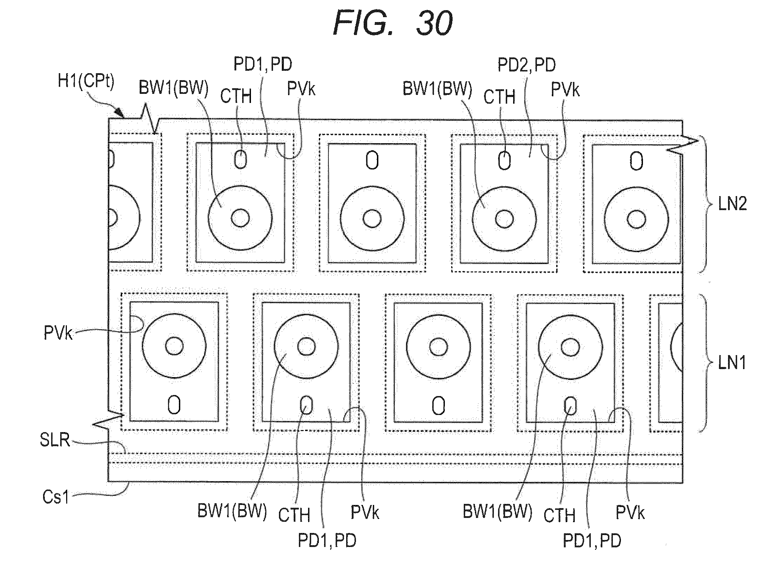

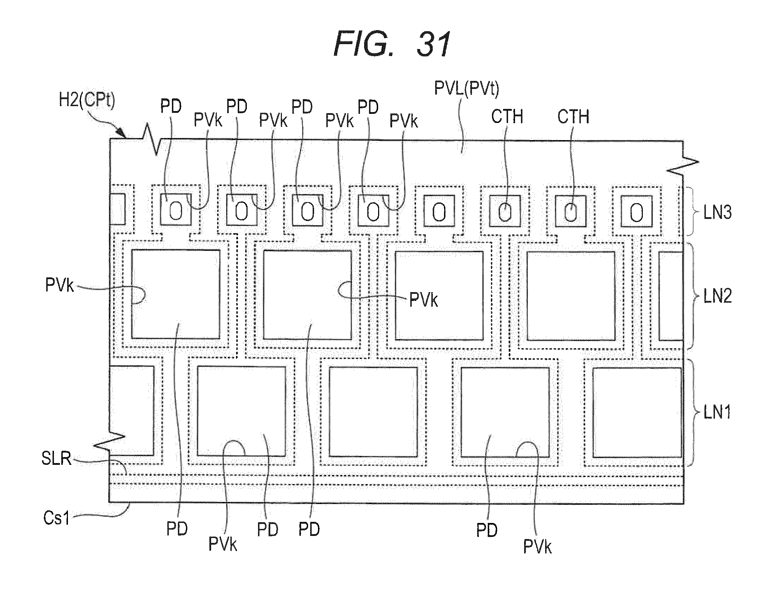

The inventors of this application have studied how to reduce the plane size of the semiconductor chip and will report the study results. FIG. 6 is an enlarged cross-sectional view of a relevant part showing the state in which a wire is attached to an electrode pad of the semiconductor chip. FIG. 7 is an enlarged plan view of the relevant part in FIG. 6. FIG. 8 is an enlarged cross-sectional view of a relevant part showing the state in which an electrical testing terminal is in contact with an electrode pad of the semiconductor chip. FIG. 9 is an enlarged plan view of the relevant part, corresponding to a plane in FIG. 8, showing an example of a probe mark imprinted after a scribing operation by a probe needle. FIG. 30 is an enlarged plan view of a comparative example, corresponding to FIG. 3. FIG. 31 is an enlarged plan view of another comparative example, corresponding to FIG. 3. In FIG. 30, wires BW are depicted to explicitly show that every electrode pad PD has a part to which a wire BW is attached and a part in which a probe mark CTH remains.

With recent progress of semiconductor integrated circuit manufacturing technology, size reduction of semiconductor elements and conductive patterns of wiring layers coupled to the semiconductor elements have been achieved. However, reduction in the plane size of electrode pads, serving as external terminals of the semiconductor chip, has been relatively delayed in comparison with the size reduction of the semiconductor elements and conductive patterns of the wiring layers coupled to the semiconductor elements. To compensate for the delay, what is needed to increase the number of the electrode pads is a technique of effectively arranging the electrode pads along the perimeter of the semiconductor chip in plan view.

Since the electrode pads are used as external terminals of the semiconductor chip, the plane size of the electrode pad needs to be determined with consideration given to the connectivity between the electrode pads and conductive members to improve the reliability of the semiconductor chip.

For instance, as shown in FIGS. 6 and 7, a wire BW and an electrode pad PD are coupled by melting a tip of the wire into the shape of a ball and bonding the ball with the electrode pad PD. Such a bonding method is called a stitch bonding method or a ball bonding method. In the stitch bonding method, a wide portion (ball) BW1, which is circular in plan view, is formed at a tip of a wire BW, and the wide portion BW1 is bonded with an exposed surface of an electrode pad PD to electrically couple the wire BW to the electrode pad PD. At the bonded interface between the wide portion BW1 and electrode pad PD, an alloy layer of the constituent materials of the wire BW and the electrode pad PD is formed.

The bond strength between the wire BW and electrode pad PD varies according to the area of the bonded interface between the wire BW and electrode pad PD, in other words, the plane area of the alloy layer. That is to say, the bond strength between the wire BW and electrode pad PD can be improved by increasing the bonding area of the wide portion BW1, which is a bonding portion of the wire BW, and the electrode pad PD. In other words, the value of the diameter (width) DM1 of the wide portion BW1 greatly influences the coupling reliability of the wire BW and electrode pad PD. Under the present circumstances, it is preferable to set the diameter DM1 shown in FIGS. 6 and 7 to, for example, 30 µm or wider to ensure the coupling reliability of the wire BW and electrode pad PD.

In addition, in order to ensure stabilized coupling of the wire BW having the wide portion BW1 with a diameter DM1 of 30 µm or wider in the wire bonding process, it is preferable to provide a clearance of 10 µm or wider around the wide portion BW1. Therefore, if the openings PVk in the protective film PVL are square in plane shape as shown in FIG. 7, a preferable length KS1 per side of the openings PVk is 50 µm or longer.

In short, in a case where the electrode pads PD are used to couple with wires, the preferable length of a side of the opening PVk is 50 µm or longer in order to ensure the coupling reliability of the wire BW and electrode pad PD.

In another case, the electrode pads PD are sometimes brought into contact with a probe needle PCT, which is an electrical testing terminal, as shown in FIG. 8 during an electrical inspection performed to check if integrated circuits over the semiconductor substrate are properly formed. The probe needle PCT is a testing terminal used to conduct an electrical inspection and is electrically coupled to a test circuit TC for the electrical inspection as schematically illustrated in FIG. 8.

In the electrical inspection process, the tip of the probe needle PCT is brought into contact with an electrode pad PD. To stabilize the contact between the probe needle PCT and electrode pad PD, it is preferable to move the probe needle PCT along the exposed surface of the electrode pad PD (hereinafter referred to as "scribing operation"), as schematically shown in FIG. 8 with an arrow, so that the tip of the probe needle PCT digs into the electrode pad PD.

The scribing operation performed by the probe needle PCT during the above-described electrical inspection leaves a probe mark CTH, as shown in FIG. 9, in the exposed surface of the electrode pad PD. If a wire BW as shown in FIG. 7 is attached to a part where the probe mark CTH has been imprinted, the probe mark CTH part can be a hindrance to alloy layer formation, and therefore it is difficult to use the part where the probe mark CTH remains as an electrode pad PD for wire bonding.

Therefore, if the electrode pad is exclusively treated as a pad for inspection without considering the function as a pad for wire bonding, the open area of the openings PVk for the electrode pad can be made smaller in comparison with the openings PVk for the wire bonding pads. In other words, the open area of the opening PVk can be reduced to an extent that the probe needle PCT does not touch the protective film PVL during the scribing operation with the probe needle PCT. For instance, as shown in FIG. 9, when the opening PVk in the protective film PVL is square in plane shape, the preferable length KS2 per side of the opening PVk is 20 µm or longer.

The open areas required for the wire bonding electrode pads PD and testing electrode pads PD are different from each other as described above; however, because the testing terminal is brought into contact with every electrode pad PD, it is possible to make the open area of the openings PVk sufficiently large enough for the electrode pad to have a region where the testing terminal comes into contact and a region where the wire BW is attached, like the semiconductor chip H1 in FIG. 30. In this case, the probe mark CTH does not overlap the wide portion BW1 of the wire BW in plan view, thereby improving the bond strength.

However, such a large plane size of the electrode pads PD as shown in FIG. 30 adds severe constraints to the layout of the electrode pads PD when there is a demand for an increase in the number of electrode pads PD. The layout constraints may possibly impede the arrangement of the necessary number of the electrode pads PD along the perimeter of the upper surface CPt. In this case, the area of the upper surface CPt needs to be expanded to ensure the space for the electrode pads PD, resulting in making the plane size of the semiconductor chip H1 larger. In addition, though detailed description will be given later, it has been found that when the semiconductor chip H1 is incorporated in a semiconductor package PKG as shown in FIG. 1, the protective film PVL is sometimes partly damaged due to temperature changes.

Hence, the inventors of this application focused on the fact that the required minimum plane size is different depending on the applications and discovered a method for effectively arranging a large number of electrode pads PD by arranging electrode pads having different plane sizes in accordance with the applications. For instance, the example in FIG. 3 indicates that among the plurality of electrode pads PD, the areas of the respective electrode pads PD1 are smaller than the areas of the respective electrode pads PD2 and electrode pads PD3.

Since the semiconductor chip CHP1 of this embodiment is provided with the electrode pads PD of different plane sizes as shown in FIG. 3, the flexibility in layout of the electrode pads PD is enhanced and effective arrangement of the electrode pads PD along the perimeter of the semiconductor chip CHP1 can be achieved. Consequently, the plane size of the semiconductor chip CHP1 can be reduced.

However, further study by the inventors of the present application revealed that just simple arrangement of the electrode pads PD of different plane sizes leaves some problems from the viewpoint of reliability. For instance, a semiconductor chip H2 shown in FIG. 31 as a comparative example has electrode pads PD formed in the first line LN1, the second line LN2, and the third line LN3 arranged in this order from a side Cs1, and the plane areas of the electrode pads PD in the first line LN1 and the second line LN2 are larger than the plane areas of the electrode pads PD in the third line LN3. In short, the electrode pads PD having relatively large plane areas are arranged near the perimeter of the semiconductor chip H2.

Since the semiconductor chip H2 is provided with the electrode pads PD having different plane sizes, the flexibility in layout of the electrode pads PD is enhanced, and effective arrangement of the electrode pads PD along the perimeter of the semiconductor chip H2 can be achieved.

However, it has been found that when the semiconductor chip H2 is incorporated in a semiconductor package PKG like the one shown in FIG. 1 and then the semiconductor package PKG is heated, the protective film PVL becomes easily cracked around the openings PVk from which the electrode pads PD are exposed. It has been also found that the cracks are apt to develop around the electrode pads PD especially formed in the first line LN1.

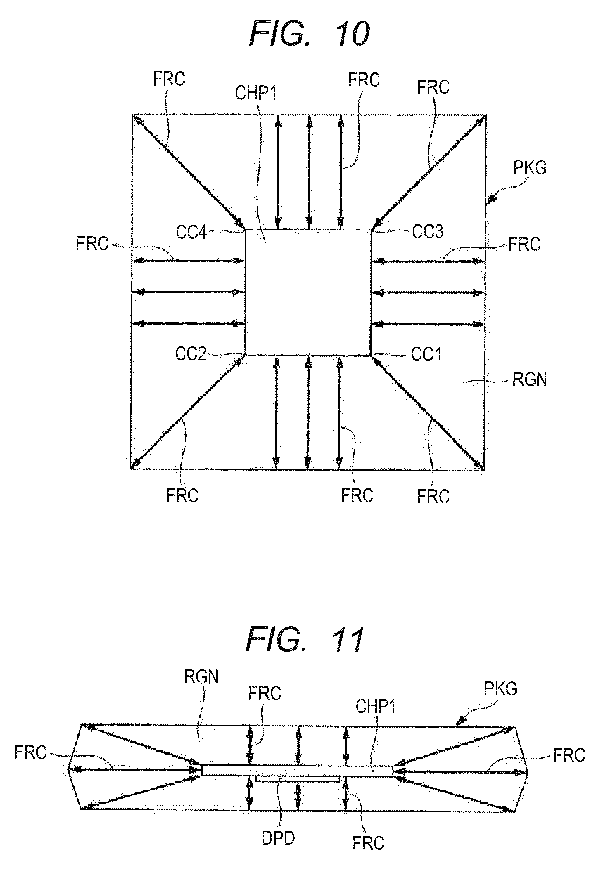

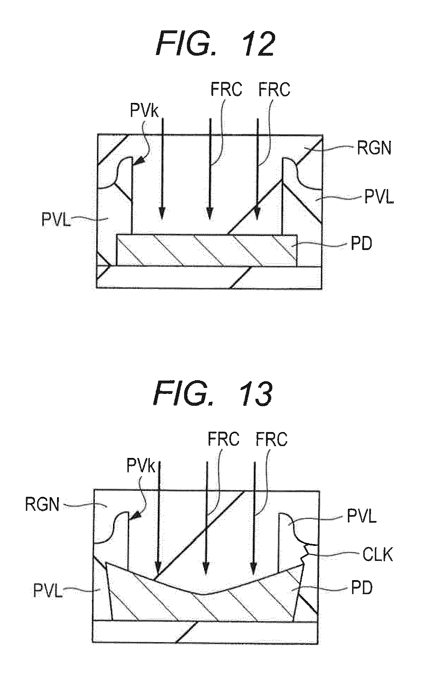

Possible causes of the cracks include the following models. FIG. 10 is an explanatory schematic diagram showing, in plan view, directions of force produced when the temperature of the semiconductor package in FIG. 1 changes. FIG. 11 is an explanatory schematic diagram showing, in cross sectional view, directions of force produced when the temperature of the semiconductor package in FIG. 1 changes. FIG. 12 is a schematic enlarged cross-sectional view of the force in FIGS. 10 and 11 applied onto an electrode pad. FIG. 13 is an enlarged cross-sectional view showing the electrode pad being deformed and cracked by the force shown in FIG. 12. FIGS. 10 to 13 schematically show by arrows the force FRC produced by temperature change of the semiconductor package PKG. Although FIG. 11 is a cross-sectional view, the semiconductor package is not hatched to make the force FRC clear to see.

To use a semiconductor package PKG shown in FIG. 1, heat may be sometimes applied to the semiconductor package PKG. For instance, when a semiconductor package PKG is mounted on a mount board (not shown), a heating process, which is called a reflow soldering, is performed to melt solder in order to electrically couple a lead LD to a terminal of the mount board. Alternatively, the semiconductor package PKG repeatedly increases and decreases in temperature in some usage environments. This is a so-called temperature cycling load that affects the semiconductor package PKG.

The temperature change in the semiconductor package PKG causes expansion or shrinkage of the constituent materials of the semiconductor package PKG. The semiconductor chip CHP1 and the resin body RGN shown in FIGS. 10 and 11 have different coefficients of thermal expansion from each other. Thus, the amounts of change (expansion or shrinkage) of the semiconductor chip CHP1 and the resin body RGN do not change in the same manner with temperature changes of the semiconductor package PKG, resulting in a difference caused by the difference in coefficient of thermal expansion. Consequently, a force FRC derived from the difference in coefficient of thermal expansion is applied to the contact interface between the semiconductor chip CHP1 and resin body RGN.

The force FRC produced with temperature changes of the semiconductor package PKG acts in directions from the perimeter of the resin body RGN toward the perimeter of the semiconductor chip CHP1 as shown in FIGS. 10 and 11. The magnitude of the force FRC increases in proportion to the distance from the perimeter of the semiconductor chip CHP1 to the perimeter of the resin body RGN. Therefore, in plan view, a greater force FRC is applied to the perimeter of the semiconductor chip CHP1 than to the center part thereof. In addition, a greater force FRC is applied to the corners, which are the intersections of the sides of the semiconductor chip CHP1, than to the other parts of the perimeter.

As shown in FIG. 12, a force FRC acts on the electrode pad toward the contact interface between the electrode pad PD and resin body RGN. The magnitude of the force FRC applied to the perimeter of the semiconductor chip CHP1 is greater as described with FIGS. 10 and 11. Electrode pads PD, for example made of aluminum, in areas receiving the great force FRC become deformed due to the impact of the force FRC. For instance, the electrode pad PD shown in FIG. 13 is deformed so that its exposed surface is recessed at the center and is humped at the perimeter by the recession.

The deformation of the electrode pad PD produces stress at the contact interface between the electrode pad PD and protective film PVL. Then, the stress is concentrated on a lowest-strength area in the contact interface between the electrode pad PD and protective film PVL and causes a crack CLK.

In the case of the model described in FIGS. 10 to 13, the greater the volume of the electrode pads PD is, the more the amount of deformation caused by the force FRC increases, and therefore more cracks CLK are produced with an increase in the volume of the electrode pads PD. Since the thicknesses of the electrode pads PD are all the same as shown in FIG. 5, the volume of the electrode pad PD can be substituted by the plane area of the electrode pads PD. In other words, the greater the plane area of the electrode pads PD is, the more the amount of deformation caused by the force FRC increases, and therefore more cracks CLK are produced with an increase in the plane area of the electrode pads PD.

Based on the study results, the inventors of the present application found the configuration of the present embodiment. Specifically, as shown in FIG. 3, electrode pads PD having a relatively large plane area are arranged further than electrode pads PD having a relatively small plane area from the side Cs1 of the perimeter of the semiconductor chip CHP1. In other words, electrode pads PD1 having a relatively small plane area are arranged in a first line LN1 that is closest to the side Cs1. Additionally, electrode pads PD2 and electrode pads PD3 having a larger plane area than the electrode pads PD1 are arranged in a second line LN2 and a third line LN3, respectively, that are further than the first line LN1 from the side Cs1.

Although the electrode pads PD1 in this embodiment are formed in the vicinity of the perimeter of the semiconductor chip CHP1 to which a relatively large force FRC is applied, the plane area of the electrode pads PD1 is small, thereby reducing the amount of deformation of the electrode pads PD1 due to force FRC. Consequently, occurrence of cracks CLK (see FIG. 13) caused by deformation of the electrode pads PD1 can be suppressed. In addition, since the electrode pads PD2 and electrode pads PD3 having a large plane area are formed further from the perimeter than the electrode pads PD1, the force FRC applied to the electrode pads PD2 and PD3 is small. Consequently, occurrence of cracks CLK (see FIG. 13) caused by deformation of either of the electrode pads PD2 and electrode pads PD3 can be reduced.

In short, the present embodiment can suppress the occurrence of cracks CLK in the protective film PVL, thereby improving the reliability of the semiconductor chip CHP1 and the semiconductor package PKG incorporating the semiconductor chip CHP1.

By the way, as shown in FIGS. 3 and 5, a seal ring SLR is formed between the electrode pads PD1 and side Cs1 of the semiconductor chip CHP1 in this embodiment. The seal ring SLR is a metal pattern made of the same metal material as that of the conductive patterns CBP of the wiring layers DL, and the uppermost wiring layer DL is made of the same material as that of the electrode pads PD, for example, a metal material mainly containing aluminum.

However, according to a study by the inventors of the present application, the metal pattern of the seal ring SLR is entirely covered with a protective film PVL and therefore is not exposed. Such a seal ring SLR is less susceptible to the force FRC as shown in FIG. 12. Therefore, the seal ring SLR is resistant to deformation as occurred in the electrode pads PD. Consequently, cracks CLK (see FIG. 13) are hard to be made around the seal ring SLR.

As described above, the respective electrode pads PD1 arranged in the first line as shown in FIG. 3 in this embodiment are testing pads with which probe needles PCT (see FIG. 8) are brought into contact. The probe needles are testing terminals used to electrically inspect circuits formed over the semiconductor chip CHP1. Because the electrode pads PD1 are testing pads, the aforementioned constraints to achieve stable wire bonding are not imposed on the plane size of the electrode pads PD1. Therefore, as shown in FIG. 3, the plane areas of the electrode pads PD1 can be made smaller than the plane areas of the electrode pads PD2 and PD3 serving as wire bonding pads. In short, in this embodiment, testing pads having a smaller plane area than that of the wire bonding pads are arranged in the first line LN1 that is closest to the perimeter of the semiconductor chip CHP1. Therefore, this embodiment can suppress occurrence of cracks CLK more effectively as shown in FIG. 13 in comparison than the case where the wire bonding pads are arranged in the first line LN1.

However, if every electrode pad PD1 is a testing pad, the wire bonding pads need to be electrically coupled to the respective testing pads. In this embodiment, as indicated by dotted lines in FIG. 3, each of the electrode pads PD1 is electrically coupled to either one of the electrode pads PD2 and electrode pads PD3.

In the example shown in FIG. 3, the electrode pads PD1 include a plurality of electrode pads PD1a electrically coupled to the electrode pads PD2 and a plurality of electrode pads PD1b electrically coupled to the electrode pads PD3. The electrode pads PD3 are electrically coupled to the respective electrode pads PD1b through respective wires WR1 . On the other hand, the electrode pads PD2 are electrically coupled to the respective electrode pads PD1a through respective wires WR2. Each of the wires WR1 is formed between the electrode pads PD2.

In the embodiment shown in FIG. 3, the wires WR2 that are shorter than the wires WR1 are formed between the electrode pads PD2 and electrode pads PD1a. However, the first line LN1 and the second line LN2 are adjacent to each other. Therefore, the electrode pads PD2 and electrode pads PD1a can be directly coupled to each other without the wires WR2 in a modification of the example in FIG. 3.

On the other hand, the electrode pads PD2 arranged in the second line LN2 are disposed between the first line LN1 and the third line LN3. To electrically couple the electrode pads PD3 and electrode pads PD1b, it is preferable to provide wires WR1 between the electrode pads PD3 and electrode pads PD1b. The width of the wire WR1 can be made smaller than any sides of the electrode pads PD1, electrode pads PD2, and electrode pads PD3. Therefore, the reduction of the space available for the electrode pads PD caused by placement of the wires WR1 can be mitigated.

In the example shown in FIG. 3, the electrode pads PD1b coupled to the electrode pads PD3 and the electrode pads PD1a coupled to the electrode pads PD2 are alternately arranged in the first line LN1. In the arrangement shown in FIG. 3, the electrode pads PD can be placed so that a part of the perimeter of each electrode pad PD3 to which the wire WR1 is attached faces a part of the perimeter of each electrode pad PD1b to which the wire WR1 is attached. This arrangement allows the wires WR1 to linearly extend, thereby shortening the length of the wires WR1.

Although the perimeter of the upper surface CPt of the semiconductor chip CHP1 contains four sides and the electrode pad group arranged along the side Cs1 out of the four sides has been described with FIG. 3 as a representative example, the electrode pad group can be arranged along the side Cs2, side Cs3, and side Cs4 in FIG. 2 in the same layout as that shown in FIG. 3.

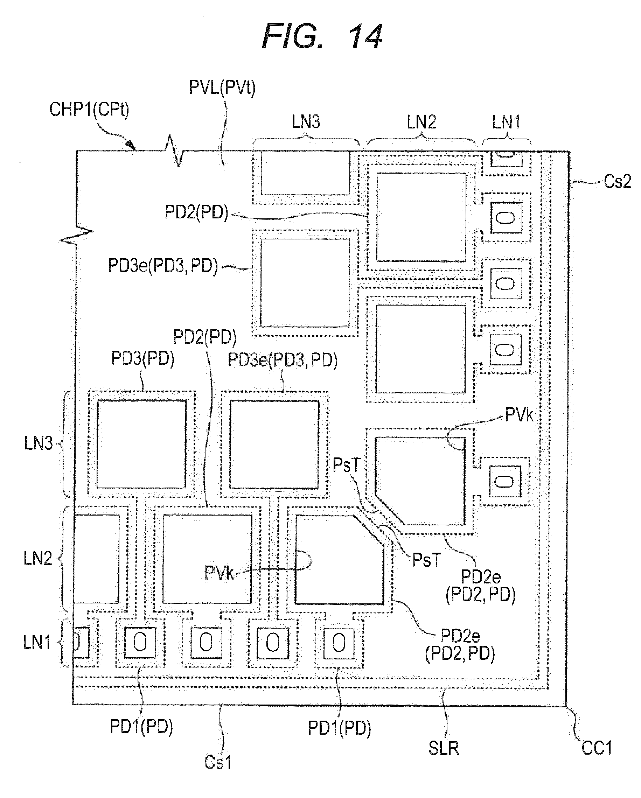

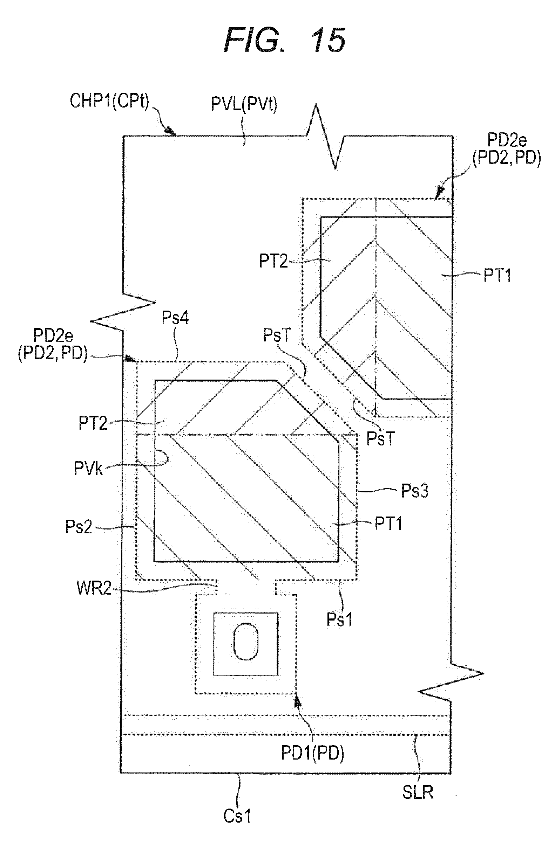

In the present embodiment, as shown in FIG. 14, among the electrode pads PD2 arranged in the second lines LN2, electrode pads (end pads) PD2e formed at ends of the lines have a different shape than the other electrode pads PD2. FIG. 14 is an enlarged plan view of part B in FIG. 2. FIG. 15 is an enlarged plan view of an electrode pad formed at an end of the second line, on a further enlarged scale, among the electrode pads shown in FIG. 14. Although FIG. 15 is a plan view, for the purpose of clearly distinguishing a part PT1 from a part PT2, which will be described later, the part PT1 and part PT2 have different hatch patterns.

As shown in FIG. 15, the electrode pads PD2 arranged along the side Cs1 of the semiconductor chip CHP1 include an electrode pad PD2e formed at an end of the line. The electrode pad PD2e has a part PT1 containing a side (pad side) Ps1 extending along the side Cs1 in plan view. The electrode pad PD2e also has a part PT2 that contains a side (inclined side, pad side) PsT inclined with respect to the side Cs1 in plan view and is formed integral with the part PT1 . In the example shown in FIG. 15, the part PT1 is quadrilateral (specifically, rectangular) and the part PT2 is trapezoidal in plan view.

The electrode pad PD2e in FIG. 15 can be also expressed as follows. The electrode pad PD2 arranged along the side Cs1 of the semiconductor chip CHP1 include an electrode pad PD2e formed at an end of a line. The electrode pad PD2e has a side (pad side) Ps1 extending along the side Cs1 in plan view. The electrode pad PD2e also has a side (pad side) Ps2 intersecting the side Ps1 in plan view. The electrode pad PD2e also has a side (pad side) Ps3 that intersects the side Ps1 in plan view, faces the side Ps2, and extends along the side Cs2 (see FIG. 14) of the semiconductor chip CHP1. The electrode pad PD2e also has a side (pad side) Ps4 that intersects the side Ps2 and faces the side Ps1 in plan view. The electrode pad PD2e also has a side (inclined side, pad side) PsT that intersects the side Ps3 and side Ps4 in plan view. The lengths of the side Ps3, side Ps4 and side PsT are shorter than the side Ps1.

The electrode pad PD2e in FIG. 15 can be also expressed as follows. The electrode pads PD2 arranged along the side Cs1 of the semiconductor chip CHP1 include an electrode pad PD2e formed at an end of a line. The electrode pad PD2e is in the shape of a quadrilateral with one chamfered corner out of four corners in plan view.

As described above with FIGS. 6 and 7, in order to ensure stabilized coupling of the wire BW having the wide portion BW1 with a diameter DM1 of 30 µm or wider in the wire bonding process, it is preferable to provide a clearance of 10 µm or wider around the wide portion BW1. When the opening PVk in the protective film PVL is square in plane shape as shown in FIG. 7, the preferable length per side of the opening PVk is 50 µm or longer. However, as shown in FIG. 7, the wide portion BW1 of the wire BW is circular in plan view. Therefore, the shape of the openings PVk is not limited to a quadrilateral and can be a quadrilateral with one chamfered corner as shown in FIG. 15 as long as a clearance of 10 µm or more can be ensured around the wide portion BW1.

It is preferable that the perimeters of the electrode pads PD are covered with the protective film PVL in plan view. In order to cover the perimeters of the electrode pads PD with the protective film PVL and to minimize the plane areas of the electrode pads PD, it is preferable to make the plane shape of the electrode pads PD similar to the open shape of the openings PVk. Therefore, if the open shape of the openings PVk is a quadrilateral having one chamfered corner as shown in FIG. 15, the plane shape of the electrode pads PD can be shaped into a quadrilateral having one chamfered corner to suit the shape of the openings PVk. Thus, the electrode pads PD2e can have an inclined side PsT in plane shape.

As shown in FIG. 15, when the electrode pad PD2e is a quadrilateral with one chamfered corner out of four corners in plan view, the plane area is smaller than that of the quadrilateral electrode pad.

Therefore, the occurrence of cracks CLK around the electrode pads PD2e as shown in FIG. 13 can be reduced. As described with FIGS. 10 and 11, an especially large force FRC is applied to the corners CC1, CC2, CC3, and CC4 of the semiconductor chip. Among the electrode pads PD, the electrode pads PD2e located in the vicinity of the corner CC1 as shown in FIG. 14 are susceptible to deformation caused by the force FRC. Reducing the plane area of the electrode pads PD2e causes the electrode pad PD2e to be less susceptible to deformation.

In addition, shaping the electrode pads PD2e into a quadrilateral with one chamfered corner out of four corners in plan view as shown in FIG. 15 results in an increase in the number of the electrode pads PD in comparison with the case of quadrilateral electrode pads.

As shown in FIG. 14, in this embodiment, an electrode pad group is arranged along the side Cs2 of the semiconductor chip CHP1 in the same manner as the electrode pad group arranged along the side Cs1 of the semiconductor chip CHP1. In this case, there is a concern that the electrode pad PD2e arranged along the side Cs1 makes contact with the electrode pad PD2e arranged along the side Cs2. Since the wires WR1 (see FIG. 3) are disposed between the electrode pads PD2 as described above, the distance between the electrode pads PD2 is longer than the distance between the electrode pads PD3. This makes it easier for the electrode pad PD2e arranged along the side Cs1 and the electrode pads PD2e arranged along the side Cs2 to make contact with each other.

A possible method for preventing the contact between the adjacent electrode pads PD2e is to reduce the number of the electrode pads PD2. For instance, in the example shown in FIG. 14, the number of the electrode pads PD3 to be arranged along the side Cs2 is reduced to prevent an electrode pad (end pad) PD3e arranged along the side Cs1 from making contact with an electrode pad PD3e arranged along the side Cs2.

However, there is no need to decrease the number of the electrode pads PD2 if the adjacent electrode pads PD2e are arranged so that their inclined sides PsT face each other as described in this embodiment. This also prevents contact between the adjacent electrode pads PD2e.

Just for the purpose of increasing the number of the electrode pads PD, it is possible to place another electrode pad PD between the seal ring SLR and the electrode pads PD2e shown in FIG. 14. However, as already described above, a very large force FRC (see FIG. 10) is applied on the vicinity of the corner CC1 of the semiconductor chip. Therefore, it is preferable not to place any electrode pads PD within a certain distance from the corner CC1 to suppress deformation of the electrode pads PD caused by the force FRC.

### <Method for manufacturing semiconductor chip (semiconductor device)>

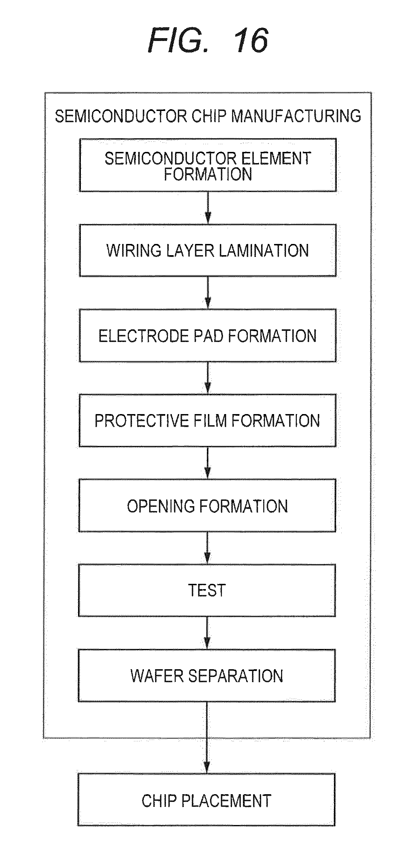

Next, a method for manufacturing the semiconductor chip shown in FIGS. 2 to 5 will be described. FIG. 16 is an explanatory diagram showing the main process flow for manufacturing the semiconductor chip shown in FIGS. 2 to 5. The semiconductor chip CHP1 (see FIG. 2) according to the present embodiment is manufactured along the flow shown in FIG. 16, for example, and is mounted on a die pad DPD shown in FIG. 1 in a chip placement process. The processes will be described below by following the flow shown in FIG. 16.

### (Semiconductor Element Formation Process)

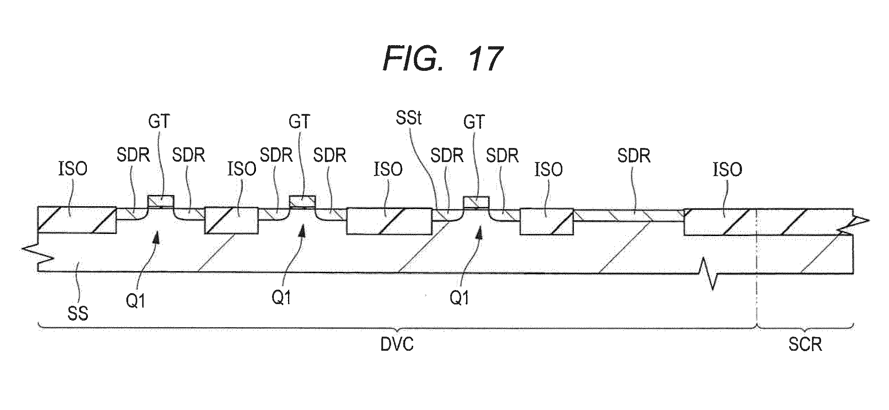

Firstly, in a semiconductor element formation process in FIG. 16, a plurality of semiconductor elements Q1 are formed over an upper surface SSt, which is an element formation surface of a semiconductor substrate SS as shown in FIG. 17. FIG. 17 is an enlarged cross-sectional view showing the state in which a plurality of semiconductor elements are formed over an element formation surface of a semiconductor substrate in a semiconductor element formation process in FIG. 16.

The first thing to do in this process is to prepare a semiconductor substrate SS. The semiconductor substrate SS is made of, for example, monocrystalline silicon and has an upper surface SSt serving as an element formation surface. The semiconductor substrate SS prepared in this process is a plate-like member roughly circular in plane shape. The semiconductor substrate SS includes device regions DVC corresponding to semiconductor chips CHP1 and scribe regions SCR that will be cut in a wafer separation process shown in FIG. 16. Because FIG. 17 is an enlarged cross-sectional view, one of the device regions DVC and one of the scribe regions SCR are partially illustrated. In reality, the semiconductor substrate SS includes two or more device regions and two or more scribe regions SCR provided between the adjacent device regions DVC. The plate-like circular member before being separated into individual pieces in the wafer separation process shown in FIG. 16 is referred to as a wafer or a semiconductor wafer.

In the example shown in FIG. 17, insulating films (field isolation film) ISO formed over the upper surface SSt of the semiconductor substrate SS function as element isolation regions that electrically isolate the regions where the semiconductor elements Q1 are formed, from one another. In some modifications, the insulating films ISO functioning as element isolation regions may not be formed.

Next, an impurity is doped into regions of the semiconductor substrate SS in which semiconductor elements Q1 are to be formed in order to form well regions (not shown). Then, gate insulating films (the reference numeral is omitted) and gate electrodes GT are formed in this order over the upper surface SSt (surface of well regions) of the semiconductor substrate SS. Then, sidewall insulating films (not shown) are formed over side walls of the gate electrodes GT. The sidewall insulating films are made from, for example, silicon dioxide films or laminated films of a silicon dioxide film and silicon nitride film.

Next, an impurity of an opposite conductivity type to the conductivity type for the well regions is ion-implanted to each of the well regions isolated by the insulating films ISO, thereby forming semiconductor regions SDR. The semiconductor regions SDR are semiconductor layers of an opposite conductivity type to that of the well regions and correspond to source regions or drain regions of semiconductor elements Q1, which are MOSFETs.

Through the foregoing process, a plurality of semiconductor elements Q1 are formed over the upper surface SSt of the semiconductor substrate SS. Although main steps for forming the semiconductor elements Q1 have been briefly described above, the semiconductor element formation process can be modified in various ways.

### (Wiring Layer Lamination Process)

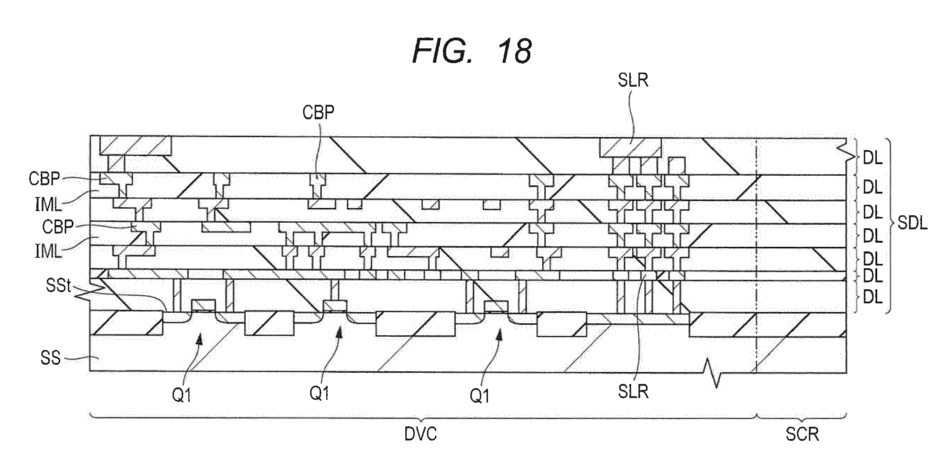

In a wiring layer lamination process shown in FIG. 16, a plurality of wiring layers DL are stacked over the upper surface SSt, which serves as an element formation surface of the semiconductor substrate SS, as shown in FIG. 18. FIG. 18 is an enlarged cross-sectional view showing the state in which the wiring layers stacked over the element formation surface of the semiconductor substrate in FIG. 17.

In this process, the wiring layers DL are stacked on top of each other by repeating a step of forming an insulating layer IML, a step of forming an opening in the insulating layer IML, a step of filling a conductive pattern (wire) CBP in the opening, and a step of polishing the upper surface of the insulating layer IML flat.

The insulating layers IML making up the wiring layers DL are made from, for example, insulating films mainly containing silicon dioxide (SiO₂). The insulating layers IML can be formed by, for example, a plasma CVD (Chemical Vapor Deposition) method.

The opening, which is formed in the insulating layer IML and is filled with a conductive pattern CBP, can be formed by, for example, performing chemical treatments, such as etching, on the insulating layer IML covered with a resist mask used to expose parts being treated. When the opening is formed by chemical treatment, such as etching, a film (e.g., silicon nitride film) having a different etched rate from the silicon dioxide is sometimes formed as an insulating barrier film. The insulating layer IML includes the insulating barrier film.

The conductive pattern CBP can be formed by a metal CVD method, a sputtering method, a combination of the metal CVD method and sputtering method, or the like. The conductive pattern CBP making up the wiring layer DL is made of mainly copper (Cu).

However, the conductive pattern CBP that is formed in the lowermost wiring layer DL in intimate contact with the semiconductor substrate SS is made of, for example, tungsten (W). The conductive pattern CBP formed in the lowermost layer is called a plug or a contact, and is coupled to a gate electrode GT, a source region, or a drain region described with FIG. 17.

Then, a barrier conductive film (not shown) is formed between the respective conductive patterns CBP and insulating layers IML. The barrier conductive film is, for example, a tantalum (Ta) film, tantalum nitride (TaN) film, or a laminated film thereof, and has a thickness of approximately 10 nm. The barrier conductive film has functions of preventing or suppressing diffusion of copper, which is a main component of the conductive patterns.

The seal ring SLR, which is formed along the perimeter of the device region DVC, is formed together with the conductive pattern CBP. Therefore, the metal material of the seal ring SLR and the constituent material of the conductive pattern CBP are identical.

In the step of polishing the upper surface of the insulating layer IML flat, for example, a CMP (Chemical Mechanical Polishing) method can be used for polishing.

The order of the aforementioned steps to form the wiring layers DL is just an example, and can be modified in various ways. In a method, for example, subsequent to forming a conductive pattern CBP, an insulating layer IML is formed so as to cover the conductive pattern CBP, and the insulating layer IML is polished to expose the conductive pattern CBP.

### (Electrode Pad Formation Process)

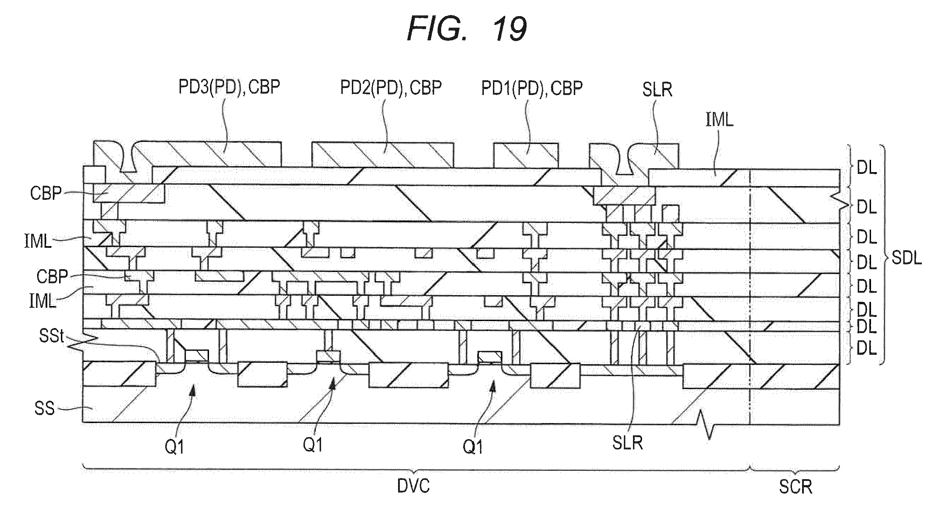

In an electrode pad formation process shown in FIG. 16, a wiring layer DL including a plurality of electrode pads PD is formed over the uppermost wiring layer DL among the wiring layers DL as shown in FIG. 19. FIG. 19 is an enlarged cross-sectional view showing the state in which the electrode pads are formed over the uppermost wiring layer in FIG. 18.

In this process, the uppermost insulating layer IML is firstly formed, and then openings are formed so as to expose parts of the conductive pattern CBP under the insulating layer IML. The insulating layer IML is formed by, for example, a plasma CVD method. The openings are formed by, for example, an etching process with use of a resist mask.

Next, a plurality of electrode pads PD are formed over the uppermost insulating layer IML, and the electrode pads PD are electrically coupled to the semiconductor elements Q1 through the conductive patterns CBP exposed in the openings.

In this process, the electrode pads PD1, electrode pads PD2, and electrode pads PD3 described with FIGS. 5 to 15 are separately formed. The electrode pads PD are patterned in accordance with the area, shape and layout specified in the section <Studies on plane size reduction of semiconductor chip>, and therefore the duplicate description is avoided.

At this stage of the process, the side Cs1, side Cs2, side Cs3, and side Cs4 of the perimeter of the semiconductor chip CHP1 shown in FIG. 2 have not been formed yet since it is before the wafer has been separated. However, as shown in FIG. 19, there is a boundary (imaginary line) between the device region DVC and the scribe region SCR on the outside of the seal ring SLR. Therefore, if the side Cs1, side Cs2, side Cs3, and side Cs4 shown in FIG. 2 are defined as sides (chip sides) making up a perimeter of the device region DVC shown in FIG. 19, the above-specified area, shape, and layout can be applied to the electrode pads PD as they are.

The electrode pads PD can be patterned, for example, by the following method. First, an aluminum film is formed over the uppermost insulating layer IML so as to cover the insulating layer IML. An exemplary method for forming the aluminum film is a sputtering method. At this stage, the aluminum film is embedded in the opening formed in the insulating layer IML.

After a resist film (not shown) is formed over the aluminum film, openings are formed in the resist film by a photolithography technique. The aluminum film under the openings is exposed from the resist film and the aluminum film to be electrode pads PD remains under the resist film.

Then, the aluminum film exposed from the resist film is removed by etching. Through this process, the electrode pads PD are patterned as shown in FIG. 2. In addition, a conductive pattern of aluminum is formed on the uppermost layer of the seal ring SLR to enclose the area where the electrode pads PD are formed.

### (Protective Film Formation Process)

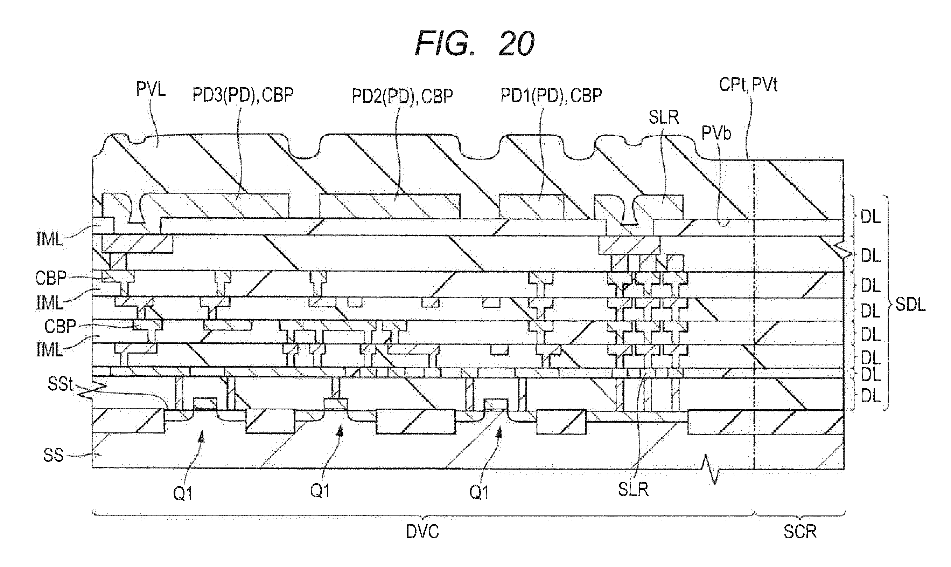

In a protective film formation process shown in FIG. 16, a protective film PVL is formed so as to cover the uppermost wiring layer DL as shown in FIG. 20. FIG. 20 is an enlarged cross-sectional view showing the state in which the protective film is formed over the uppermost wiring layer shown in FIG. 19.

The protective film PVL formed in this process is made of, for example, silicon dioxide or silicon nitride. The protective film PVL can be formed by, for example, a plasma CVD method. As shown in FIG. 20, the protective film PVL has a lower surface PVb facing the uppermost wiring layer DL and an upper surface PVt on the opposite side of the lower surface PVb. On occasion, the protective film PVL takes the form of a laminated body of a plurality of films. In this case, the lower surface of the lowermost film corresponds to the lower surface PVb, and the upper surface of the uppermost film corresponds to the upper surface PVt.

The lower surface PVb of the protective film PVL is in intimate contact with the uppermost insulating layer IML, the electrode pads PD, and the seal ring SLR arranged along the perimeter of the device region DVC. The upper surface PVt of the protective film PVL has bumps and dents to follow along the shape of the electrode pads PD and seal ring SLR.

### (Opening Formation Process)

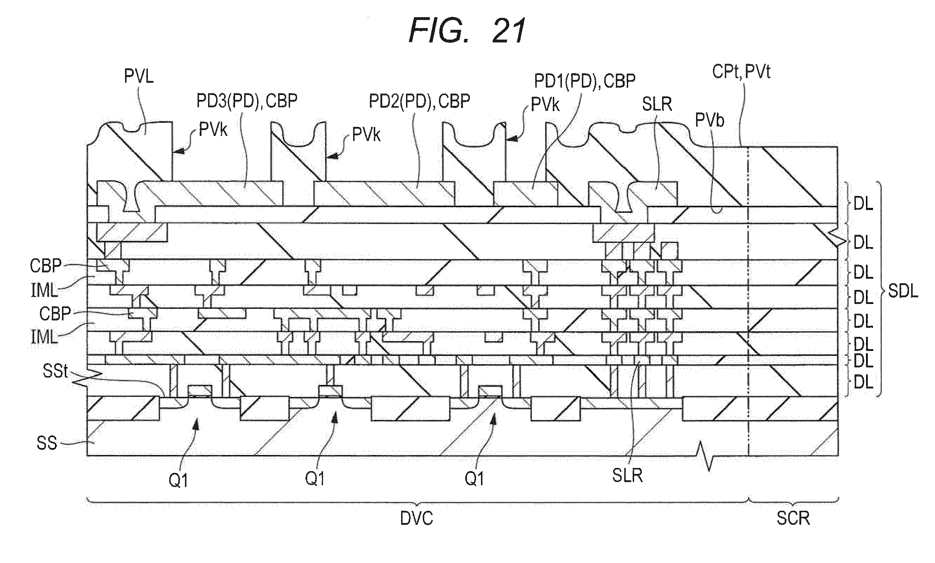

In an opening formation process shown in FIG. 16, a plurality of openings PVk are formed in the protective film PVL to expose part of the respective electrode pads PD as shown in FIG. 21. FIG. 21 is an enlarged cross-sectional view showing the state in which the openings are formed in the protective film in FIG. 20.

In this process, after a resist film (not shown) is formed over the protective film PVL, openings are formed in the resist film by a photolithography technique. The protective film PVL under the openings is exposed from the resist film.

Then, an etching process removes the exposed parts of the protective film PVL. Consequently, a plurality of openings PVk, for example, patterned as shown in FIGS. 3 and 14, can be formed.

Additionally, in this process, the electrode pads PD have the perimeters covered with the protective film PVL in plan view. In other words, the perimeters of the electrode pads PD are positioned outside from the outline of the openings PVk. Accordingly, the electrode pads PD can be protected by the protective film PVL.

### (Test Process)

In a test process shown in FIG. 16, electrical inspection is performed on circuits formed in the device region DVC (see FIG. 21).

In this process, as described with FIGS. 8 and 9, a probe needle PCT, which is an electrical testing terminal, is brought into contact with the electrode pads PD to electrically inspect integrated circuits formed over the semiconductor substrate for normality.

In this embodiment, the electrode pads PD1 (see FIG. 3), which are arranged in the first line LN1 (see FIG. 3) closest from the perimeter of the device region, are the testing pads. Thus, the tip of the probe needle PCT is brought into contact with the electrode pads PD1 as shown in FIG. 8. To stabilize the contact between the probe needle PCT and electrode pad PD, the probe needle PCT is moved along the exposed surface of the electrode pad PD (referred to as "scribing operation"), as schematically shown in FIG. 8 with an arrow, so that the tip of the probe needle PCT digs into the electrode pad PD.

Through the scribing operation, a probe mark CTH is imprinted in the exposed surface of the electrode pad PD1 as shown in FIG. 9. Since wires are not attached to the electrode pads PD1 in this embodiment, the plane size of the electrode pad PD1 can be made small. In other words, the open area of the opening PVk can be reduced to an extent that the probe needle PCT does not touch the protective film PVL during the scribing operation with the probe needle PCT. Also, the reduction in the open area of the openings PVk can reduce the plane size of the electrode pads PD1.

Furthermore, the size reduction of the plane of the electrode pads PD1 can suppress the occurrence of cracks CLK (see FIG. 13) caused by deformation of the electrode pads PD1.

### (Wafer Separation Process)

In a wafer separation process shown in FIG. 16, a wafer (an assembly with which the wiring section SDL and protective film PVL are formed over the semiconductor substrate SS) is cut along scribe regions SCR shown in FIG. 21 into device regions DVC.

In this process, for example, the wafer is cut by removing the scribe regions SCR by a rotary type cutting tool, called a dicing saw. There are various modifications of the method for cutting the scribe regions SCR. In one method, for example, a laser beam is applied to fuse and cut the material of the scribe regions SCR. Another method utilizes the laser beam and dicing saw in combination.

### <Method for manufacturing semiconductor package (semiconductor device)>

Next, a method for manufacturing the semiconductor package PKG shown in FIG. 1 will be briefly described. Cutting the scribe regions SCR in the above-described wafer separation process provides the semiconductor chips CHP1 shown in FIGS. 2 to 5.

The semiconductor chip CHP1 is placed on a die pad DPD shown in FIG. 1 (chip placement process in FIG. 16), then a plurality of wires BW are coupled to the respective electrode pads PD2 and electrode pads PD3 shown in FIG. 2 (wire bonding process). After the wire bonding process, a resin body RGN is formed around the semiconductor chip CHP1 and the wires BW shown in FIG. 1 (sealing process). In the case of the example shown in FIG. 1, a process of forming a plurality of leads LD is performed subsequent to the sealing process to obtain the semiconductor package PKG shown in FIG. 1.

### <Modifications>

It should be further understood by those skilled in the art that although the foregoing description has been made on an embodiment of the invention by the inventors of the present application, the invention is not limited thereto and various changes and modifications may be made without departing from the spirit of the invention and the scope of the appended claims.

### [First Modification]

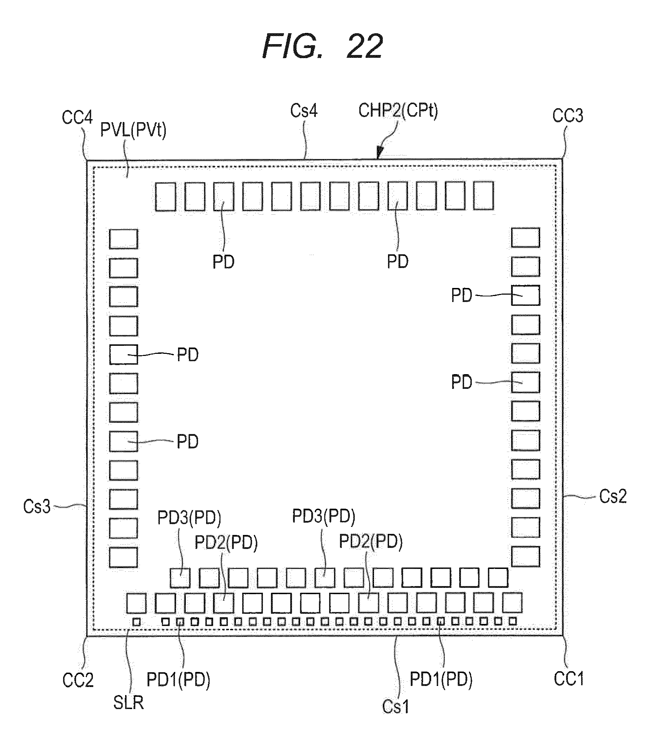

In the above-described embodiment, the perimeter of the upper surface CPt of the semiconductor chip CHP1 in FIG. 2 includes four sides, and electrode pad groups along the side Cs2, side Cs3, and side Cs4 are arranged in the same layout as the electrode pad group arranged as shown in FIG. 3. However, there is no problem if the electrode pads are arranged in the same layout as FIG. 3 along only one of the four sides of the perimeter of the upper surface CPt (along only the side Cs1 in FIG. 22), like a semiconductor chip CHP2 in FIG. 22. FIG. 22 is a plan view of a modification, corresponding to FIG. 2.

The semiconductor chip CHP2 in FIG. 22 has a plurality of electrode pad groups whose electrode pads are arranged in a single line, along the side Cs2, side Cs3, and side Cs4 among the four sides of the perimeter of the upper surface CPt. The other configurations are the same as the semiconductor chip CHP1 according to the aforementioned embodiment.

The semiconductor chip CHP2 includes a plurality of circuits formed thereon and therefore the number of necessary electrodes varies in accordance with the types of the circuits. Thus, the number of the electrode pads PD arranged along one of the four sides (side Cs1 in FIG. 22) may sometimes become extremely larger than the number of the electrode pads PD arranged along the other sides, as shown in the semiconductor chip CHP2, depending on the layout of the circuits.

In this case, the plane size of the semiconductor chip CHP2 can be reduced by laying out the group of the electrode pads PD being large in number along the side Cs1 in the manner as described in the aforementioned embodiment. In addition, if the electrode pads PD1 with a small plane area are arranged in the vicinity of the perimeter of the semiconductor chip CHP2, deformation of the electrode pads PD1 caused by temperature change of the semiconductor package incorporating the semiconductor chip CHP2 can be reduced. Consequently, occurrence of cracks CLK (see FIG. 13) caused by deformation of the electrode pads PD1 can be suppressed.

### [Second Modification]

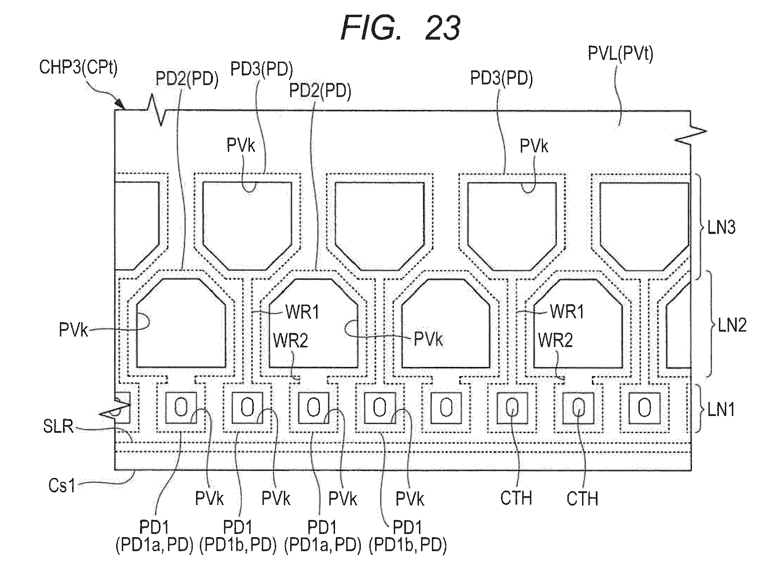

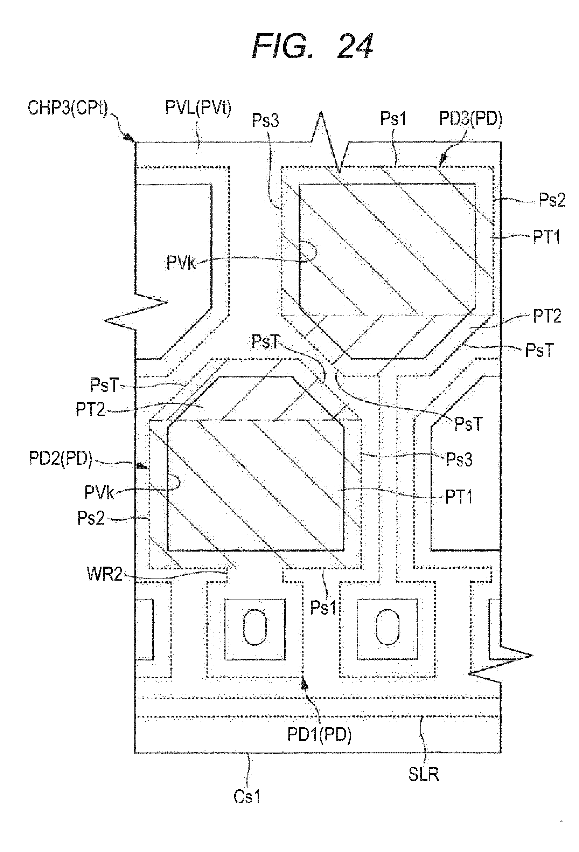

In the above-described embodiment, the electrode pads PD are quadrilateral in plan view except for the electrode pad PD2e formed at the end of the line as shown in FIGS. 14 and 15. However, like the semiconductor chip CHP3 shown in FIGS. 23 and 24, the electrode pads PD2, PD3 can be shaped into a quadrilateral with one chamfered corner out of four corners in plan view.

FIG. 23 is an enlarged plan view of a modification, corresponding to FIG. 3. FIG. 24 is an enlarged plan view of some of the electrode pads in FIG. 23 on a further enlarged scale. Although FIG. 24 is a plan view, for the purpose of clearly distinguishing a part PT1 from a part PT2, which will be described later, the part PT1 and part PT2 have different hatch patterns.

The semiconductor chip CHP3 in FIGS. 23 and 24 is different from the semiconductor chip CHP1 in FIG. 3 regarding the plane shape of the electrode pads PD2 and electrode pads PD3 among the plurality of electrode pads PD and the shape of the openings PVk. The other configurations are the same as those of the semiconductor chip CHP1 according to the embodiment.

As shown in FIG. 24, the semiconductor chip CHP3 has a plurality of electrode pads PD2 and a plurality of electrode pads PD3 arranged along the side Cs1, and each of the electrode pads PD2 and PD3 has a part PT1 containing a side (pad side) Ps1 extending along the side Cs1 in plan view. In addition, each of the electrode pads PD2 and PD3 has a part PT2 that contains a plurality of sides (inclined sides, pad sides) PsT inclined with respect to the side Cs1 in plan view and is formed integral with the part PT1. In the example shown in FIG. 24, the part PT1 is quadrilateral (specifically, rectangular) and the part PT2 is trapezoidal in plan view.

The electrode pads PD2 and electrode pads PD3 shown in FIG. 24 can be also expressed as follows. Each of the electrode pads PD2 and PD3 arranged along the side Cs1 of the semiconductor chip CHP3 has a side (pad end side) Ps1 extending along the side Cs1 in plan view. Each of the electrode pads PD2 and PD3 also has a side (pad side) Ps2 intersecting the side Ps1 in plan view. Each of the electrode pads PD2 and PD3 has a side (pad side) Ps3 that intersects the side Ps1, faces the side Ps2, and extends along the side Cs2 of the semiconductor chip CHP3 (see FIG. 14) in plan view. Each of the electrode pads PD2 and PD3 has a side (pad side) PsT that intersects with the side Ps2 and inclines with respect to the side Ps1 in plan view. Each of the electrode pads PD2 and PD3 has a side (pad side) PsT that intersects with the side Ps3 and inclines with respect to the side Ps1 in plan view. Also, the length of the respective sides PsT is shorter than the side Ps1.

The electrode pads PD2 and electrode pads PD3 shown in FIG. 24 can be also expressed as follows. Each of the electrode pads PD2 and PD3 arranged along the side Cs1 of the semiconductor chip CHP3 has the shape of a quadrilateral with two or more chamfered corners out of four corners (two in FIG. 24) in plan view.

In the semiconductor chip CHP3, each of the inclined sides PsT of the electrode pads PD2 and each of the inclined sides PsT of the electrode pads PD3 are formed to face each other. Therefore, as shown in FIG. 23, the second line LN2 partly overlaps the third line LN3 in plan view. According to the modification, the space used to arrange the electrode pads PD can be further reduced in comparison with the semiconductor chip CHP1 in FIG. 3.

### [Third Modification]

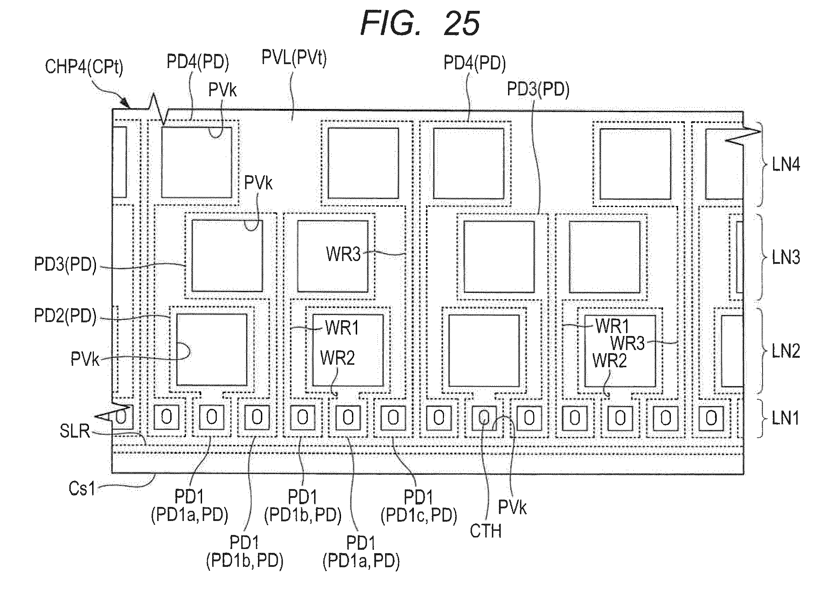

In the above-described embodiment, a plurality of electrode pads PD are arranged in three lines along the sides of the perimeter of the semiconductor chip CHP1. However, the number of lines along which the electrode pads PD are arranged can be modified in various ways. For instance, the semiconductor chip CHP4 in FIG. 25 has electrode pads PD arranged in four lines along the side Cs1.

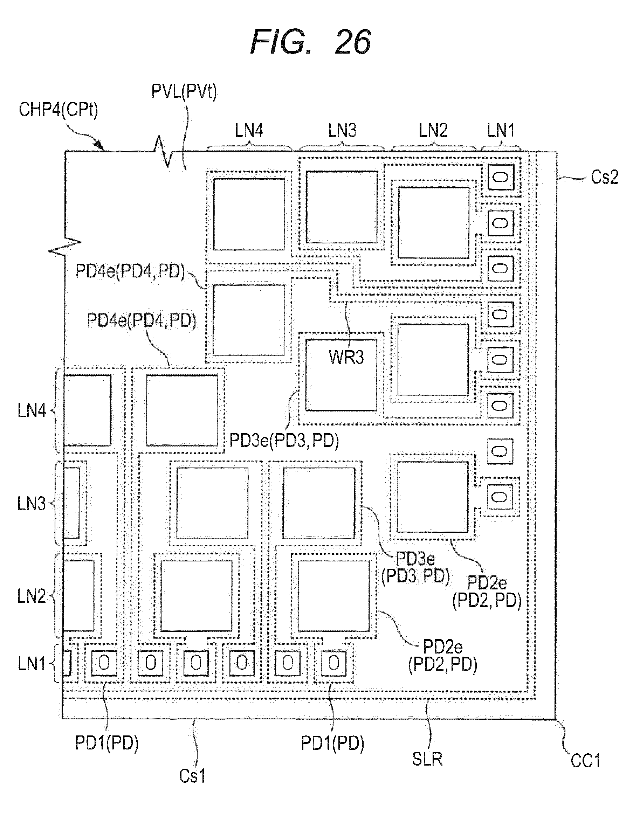

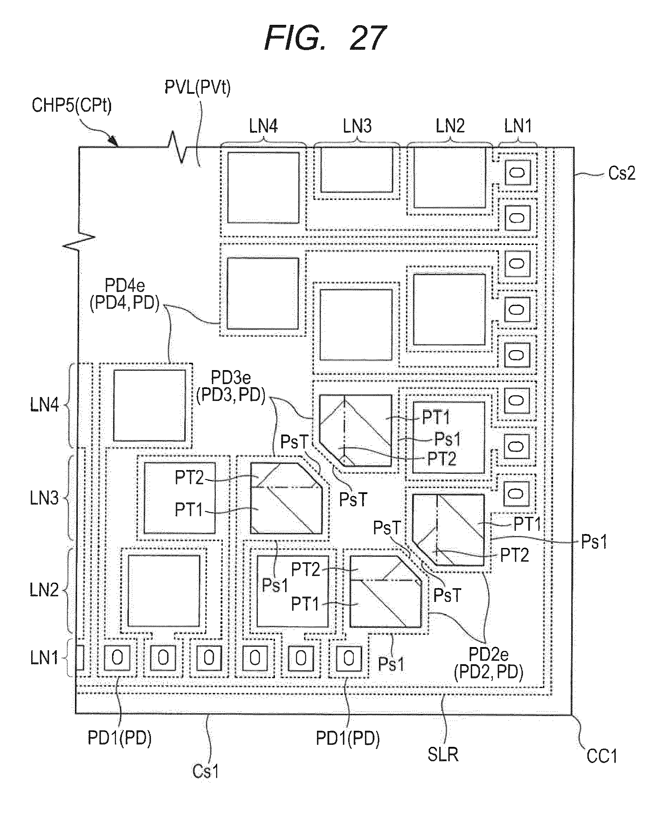

FIG. 25 is an enlarged plan view of another modification, corresponding to FIG. 3. FIG. 26 is an enlarged plan view of the electrode pads formed at ends of the lines shown in FIG. 25. FIG. 27 is an enlarged plan view of a modification, corresponding to FIG. 26. Although FIG. 27 is a plan view, for the purpose of clearly distinguishing a part PT1 from a part PT2, which will be described later, the part PT1 and part PT2 have different hatch patterns.

The electrode pads PD of the semiconductor chip CHP4 in FIG. 25 include a plurality of electrode pads (fourth-line electrode pads) PD4 formed in the fourth line LN4 located further than the third line LN3 from the side Cs1 in plan view.

As shown in FIG. 25, the area of each electrode pad PD1 is smaller than the area of each electrode pad PD4. In other words, the electrode pads PD1 with a relatively small plane area are formed in the vicinity of the perimeter of the semiconductor chip CHP4. Therefore, deformation of the electrode pads PD1 caused by temperature change of the semiconductor package incorporating the semiconductor chip CHP4 can be reduced. Consequently, occurrence of cracks CLK (see FIG. 13) caused by deformation of the electrode pads PD1 can be suppressed.

Among the plurality of electrode pads PD shown in the example of FIG. 25, the electrode pads PD1 arranged in the first line are testing pads with which a probe needle PCT (see FIG. 8) is brought into contact during the test process described in the aforementioned embodiment. On the other hand, the electrode pads PD2, PD3, PD4 are wire bonding pads to which the wires BW (see FIG. 6) are attached during the wire bonding process described in the section <method for manufacturing semiconductor package (semiconductor device)>.

Therefore, the electrode pads PD1 include electrode pads PD1b electrically coupled to the electrode pads PD3 via wires WR1, electrode pads PD1a electrically coupled to the electrode pads PD2 via wires WR2, and electrode pads PD1c electrically coupled to the electrode pads PD4 via wires WR3.

In addition, wires WR3 are formed between the adjacent electrode pads PD3 and between the adjacent electrode pads PD2 to electrically couple the electrode pads PD4 to the electrode pads PD1c. Therefore, the wires WR3 can be formed linearly.

As shown in FIG. 26, the wires WR3 for the electrode pads PD placed at the ends of a line are formed so as to have bend portions in order to increase the number of the electrode pads per line. Thus, the wires WR3 can be routed in accordance with the arrangement of the electrode pads PD.

In the example shown in FIG. 26, the electrode pads PD2e, PD3e, PD4e, which are placed at the ends of the respective lines, are quadrilateral in plan view. However, like the semiconductor chip CHP5 in FIG. 27, the electrode pads PD2e and PD3e placed at the ends of the lines can be shaped into a quadrilateral with one chamfered corner out of four corners in plan view.

As shown in FIG. 27, each of the electrode pads PD2e is formed at an end of the line in which the electrode pads PD2 are arranged along the side Cs1 of the semiconductor chip CHP5 and at an end of the line in which the electrode pads PD2 are arranged along the side Cs2. The electrode pads PD2e include parts PT1, each containing a side Ps1 extending along the side Cs1 or side Cs2 in plan view. In addition, the electrode pads PD2e include parts PT2, each containing a side PsT inclined with respect to the side Cs1 or side Cs2 in plan view and being formed integral with the part PT1. In the example shown in FIG. 27, the parts PT1 are quadrilateral (specifically, rectangular) and the parts PT2 are trapezoidal in plan view.

In addition, each of the electrode pads PD3e is formed at an end of the line in which the electrode pads PD3 are formed along the side Cs1 of the semiconductor chip CHP5 and at an end of the line in which the electrode pads PD3 are formed along the side Cs2. The electrode pads PD3e include parts PT1, each containing a side Ps1 extending along the side Cs1 or side Cs2 in plan view. In addition, the electrode pads PD3e include parts PT2 , each containing a side PsT inclined with respect to the side Cs1 or side Cs2 in plan view and being formed integral with the part PT1. In the example shown in FIG. 27, the parts PT1 are quadrilateral (specifically, rectangular) and the parts PT2 are trapezoidal in plan view.

The adjacent electrode pads PD2e are arranged so that their inclined sides PsT face each other. The adjacent electrode pads PD3e are arranged so that their inclined sides PsT face each other. The arrangement according to this modification prevents contact between the adjacent electrode pads PD2e or between the adjacent electrode pads PD3e without reduction in the number of the electrode pads PD2 and electrode pads PD3 as described in the embodiment with FIGS. 14 and 15.

The semiconductor chip CHP4 shown in FIGS. 25 and 26 and the semiconductor chip CHP5 shown in FIG. 27 are the same as the semiconductor chip CHP1 according to the embodiment except for the aforementioned differences, and therefore the duplicate description will be omitted.

### [Fourth Modification]

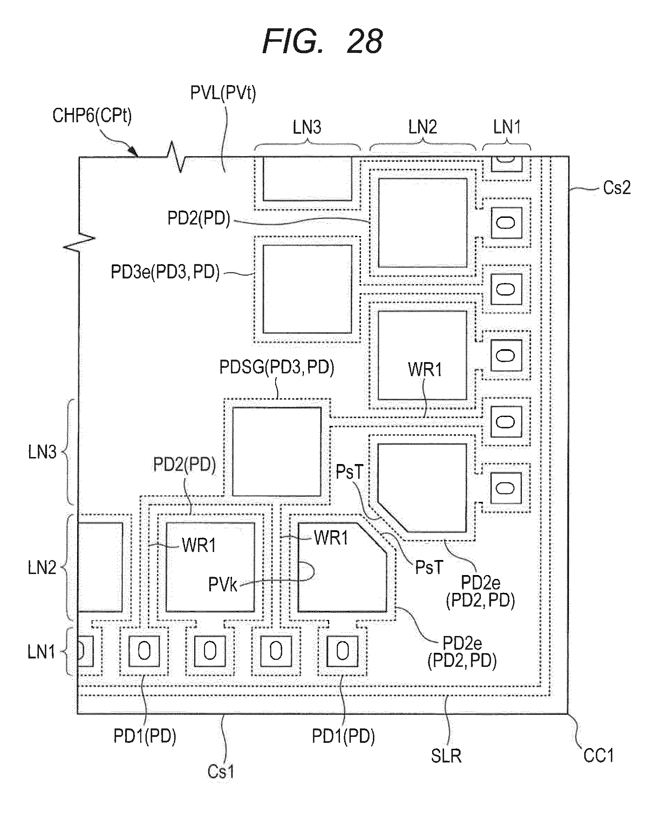

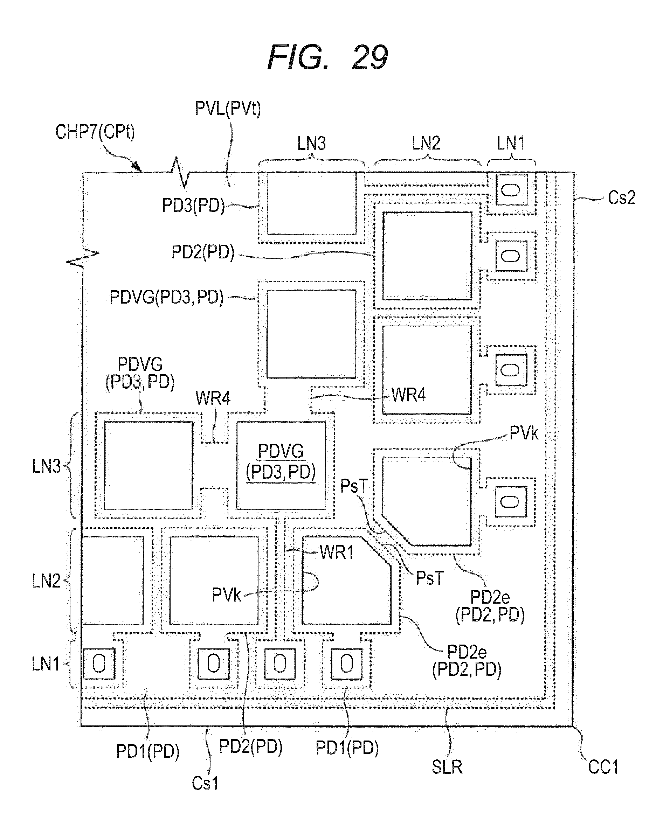

In the above-described embodiment, the electrode pads PD for wire bonding and the electrode pads PD for testing are electrically coupled in a one-to-one relationship. However, a modification may allow a plurality of testing electrode pads PD to be coupled to a single wire bonding electrode pad PD. In addition, it is possible to electrically couple a plurality of wire bonding electrode pads PD to one another and then to couple the coupled wire bonding electrode pads to a single testing electrode pad PD. FIGS. 28 and 29 are enlarged plan views of modifications, corresponding to FIG. 14.

Electrode pads PD formed in a third line LN3 of a semiconductor chip CHP6 shown in FIG. 28 include an electrode pad (signal electrode pad) PDSG through which signal current flows. The electrode pad PDSG is an input terminal used to input electrical signals to a circuit formed over the semiconductor chip CHP6, an output terminal used to output electrical signals from the circuit to the outside, or an input/output terminal used to input and output electrical signals. For the electrode pad PD used to input or output electrical signals, it may be sometimes preferable to reduce the contact resistance between the probe needle PCT (see FIG. 8) and electrode pad PD in the test process described in the aforementioned embodiment.

Therefore, in the modification in FIG. 28, a plurality of testing electrode pads PD1 are coupled to the signal electrode pad PDSG. Specifically, a single signal electrode pad PD is electrically coupled to the plurality of electrode pads PD1 through a plurality of wires WR1. This modification makes it possible to simultaneously bring probe needles PCT into contact with the plurality of electrode pads PD1 coupled to the single signal electrode pad PD in the test process. This reduces the resistance imposed on the transmission path coupling the probe needles PCT and signal electrode pad PD, thereby providing correct test results.

Although the signal electrode pad PDSG is placed at an end of a line in the modification in FIG. 28, the signal electrode pad PDSG can be placed in the middle of the line in another modification.

In addition, electrode pads PD formed along a third line LN3 of a semiconductor chip CHP7 in FIG. 29 include a plurality of electrode pads (potential supply pad) PDVG that receive a power-source potential or ground potential and are coupled to one another. The power-source potential or ground potential (reference potential, GND potential) is supplied to circuits formed over the semiconductor chip CHP7 through the electrode pads PDVG.

When the electrode pads PDVG used to supply the power-source potential and ground potential are provided, for example, a plurality of electrode pads PD coupled at the same potential may be sometimes used for the purpose of raising the ground potential to be supplied to the circuits or enhancing the current-supplying performance of the input/output circuits. On the other hand, tests can be stably conducted in the above-described test process without consideration of contact resistance between the probe needle PCT (see FIG. 8) and electrode pads PD.

In this modification as shown in FIG. 29, the coupled electrode pads PDVG for supplying a potential are coupled to a common single testing electrode pad PD. Specifically, the electrode pads PDVG are electrically coupled to one another through wires WR4. One of the coupled electrode pads PDVG is electrically coupled to a testing electrode pad PD1 through a wire WR1.

This can dispense with wires WR1 for the other electrode pads PDVG, thereby saving space for the wires WR1. If the saved space is used to place the electrode pads PD, the number of the electrode pads PD2 to be arranged in the second line may be increased, for example.

Although the example in FIG. 29 demonstrates the potential-supplying electrode pads PDVG arranged at the ends of the lines, in yet another modification, a plurality of potential-supplying electrode pads PDVG can be placed in the middle of the lines.

The semiconductor chip CHP6 in FIGS. 28 and the semiconductor chip CHP7 in FIG. 29 are the same as the semiconductor chip CHP1 according to the embodiment except for the aforementioned differences, and therefore the duplicate description will be omitted.

### [Fifth Modification]

Furthermore, the modifications noted in the foregoing can be combined and applied together within the scope of the technical idea described in the above-described embodiment.

## Claims

1. A semiconductor device comprising:
a semiconductor substrate having an element formation surface;
a first insulating film that has a first surface facing the semiconductor substrate, a second surface opposite to the first surface, and a plurality of openings passing therethrough from one of the first surface and the second surface to the other in the thickness direction, and is formed so as to cover the element formation surface of the semiconductor substrate; and
a plurality of electrode pads that are formed between the first insulating film and the semiconductor substrate, and are exposed from the first insulating film at positions overlapping the openings in the first insulating film,
wherein, the electrode pads include:
a plurality of the first-line electrode pads formed in a first line along a first chip side of a perimeter of the second surface in plan view;
a plurality of second-line electrode pads formed in a second line along the first chip side, the second line located further than the first line from the first chip side in plan view; and
a plurality of third-line electrode pads formed in a third line along the first chip side, the third line located further than the second line from the first chip side in plan view, and
wherein, the areas of the respective first-line electrode pads are smaller than the areas of the respective second-line electrode pads and the respective third-line electrode pads.

2. The semiconductor device according to claim 1,
wherein, the first-line electrode pads include:
a plurality of first electrode pads electrically coupled to the third-line electrode pads through a plurality of first wires; and
a plurality of second electrode pads electrically coupled to the second-line electrode pads, and
wherein, each of the first wires is formed between the second-line electrode pads.

3. The semiconductor device according to claim 1,
wherein, the first-line electrode pads are electrically coupled to the second-line electrode pads and the third-line electrode pads,
wherein, each of the first-line electrode pads is a testing pad with which a testing terminal is brought into contact during electrical inspection performed on a circuit formed over the semiconductor device, and
wherein, each of the second-line electrode pads and the third-line electrode pads is a wire bonding pad.

4. The semiconductor device according to claim 1,
wherein, a metal pattern extending along the perimeter of the second surface is formed between the first chip side and the first-line electrode pads in plan view, and
wherein, the first-line electrode pads, the second-line electrode pads, and the third-line electrode pads are formed in an area enclosed by the metal pattern.

5. The semiconductor device according to claim 1,
wherein, the second surface includes a second chip side intersecting the first chip side,
wherein, the second-line electrode pads include an end pad formed at an end of the second line and the end pad includes:
a first part that contains a first pad side extending along the first chip side of the second surface in plan view; and
a second part that contains an inclined side inclined with respect to the first chip side in plan view and is formed integral with the first part.

6. The semiconductor device according to claim 1,
wherein, each of the second-line electrode pads and the third-line electrode pads includes:
a first part that contains a first pad side extending along the first chip side of the second surface in plan view; and
a second part that contains a plurality of inclined sides inclined with respect to the first chip side in plan view and is formed integral with the first part, and
wherein, the inclined sides of the second-line electrode pads are arranged so as to face the respective inclined sides of the third-line electrode pads in plan view.

7. The semiconductor device according to claim 1,
wherein, the electrode pads include a plurality of fourth-line electrode pads formed in a fourth line along the first chip side, the fourth line being located further than the third line from the first chip side in plan view, and
wherein, the areas of the respective first-line electrode pads are smaller than the areas of the respective fourth-line electrode pads.

8. The semiconductor device according to claim 7,
wherein, the first-line electrode pads include a plurality of third electrode pads that are electrically coupled to the fourth-line electrode pads through a plurality of second wires, and
wherein, each of the second wires is formed between the second-line electrode pads and between the third-line electrode pads.

9. The semiconductor device according to claim 8,
wherein, the second surface includes a second chip side intersecting the first chip side,
wherein, the second-line electrode pads and the third-line electrode pads include a plurality of end pads formed at ends of the respective lines, and each of the end pads includes:
a first part that contains a first pad side extending along the first chip side of the second surface in plan view; and
a second part that contains an inclined side inclined with respect to the first chip side in plan view and is formed integral with the first part.

10. The semiconductor device according to claim 1,
wherein, each of the first-line electrode pads is a testing pad with which a testing terminal is brought into contact during electrical inspection performed on a circuit formed over the semiconductor device,
wherein, each of the second-line electrode pads and the third-line electrode pads is a wire bonding pad,
wherein, the third-line electrode pads include a signal electrode pad through which signal current flows, and
wherein, the signal electrode pad is electrically coupled to two or more of the first-line electrode pads through the respective first wires.

11. The semiconductor device according to claim 1,
wherein, each of the first-line electrode pads is a testing pad with which a testing terminal is brought into contact during electrical inspection performed on a circuit formed over the semiconductor device,
wherein, each of the second-line electrode pads and the third-line electrode pads is a wire bonding pad,
wherein, the third-line electrode pads include a plurality of potential supply pads that are supplied with power-source potential or ground potential and are electrically coupled to one another, and
wherein, the potential supply pads are electrically coupled to one of the first-line electrode pads through one of the first wires.

12. The semiconductor device according to claim 1,
wherein, the first-line electrode pads, the second-line electrode pads, and the third-line electrode pads are made of a metal material mainly containing aluminum.

13. A semiconductor device comprising:
a semiconductor chip with a plurality of electrode pads;
a plurality of wires bonded to the electrode pads; and
a resin body sealing the bonding parts between the electrode pads and the wires,
the semiconductor chip including:
a semiconductor substrate having an element formation surface;
a first insulating film that has a first surface facing the semiconductor substrate, a second surface opposite to the first surface, and a plurality of openings passing therethrough from one of the first surface and the second surface to the other in the thickness direction, and is formed so as to cover the element formation surface of the semiconductor substrate; and
a plurality of electrode pads that are formed between the first insulating film and the semiconductor substrate, and are exposed from the first insulating film at positions overlapping the openings in the first insulating film,
wherein, the electrode pads include:
a plurality of the first-line electrode pads formed in a first line along a first chip side of a perimeter of the second surface in plan view;
a plurality of second-line electrode pads formed in a second line along the first chip side, the second line located further than the first line from the first chip side in plan view; and
a plurality of third-line electrode pads formed in a third line along the first chip side, the third line located further than the second line from the first chip side in plan view, and
wherein, the areas of the respective first-line electrode pads are smaller than the areas of the respective second-line electrode pads and the respective third-line electrode pads.

14. The semiconductor device according to claim 13,
wherein, the first-line electrode pads are electrically coupled to the second-line electrode pads and the third-line electrode pads,
wherein, the wires are coupled to the second-line electrode pads and the third-line electrode pads among the plurality of electrode pads, and
wherein, the wires are not coupled to the first-line electrode pads.

15. A method for manufacturing a semiconductor device comprising the steps of:
(a) forming a plurality of semiconductor elements over an element formation surface of a semiconductor substrate;
(b) stacking a plurality of wiring layers one by one over the element formation surface of the semiconductor substrate;
(c) forming a first wiring layer including a plurality of electrode pads over the uppermost wiring layer in the wiring layers;
(d) forming a first insulating layer so as to cover the first wiring layer, the first insulating layer having a first surface facing the first wiring layer and a second surface opposite to the first surface; and
(e) forming a plurality of openings in the first insulating layer to expose the electrode pads,
wherein, the electrode pads formed in step (c) include:
a plurality of first-line electrode pads formed in a first line along a first chip side of a perimeter of a device region in plan view;
a plurality of second-line electrode pads formed in a second line along the first chip side, the second line located further than the first line from the first chip side in plan view; and
a plurality of third-line electrode pads formed in a third line along the first chip side, the third line located further than the second line from the first chip side in plan view, and
wherein, the areas of the respective first-line electrode pads are smaller than the areas of the respective second-line electrode pads and the respective third-line electrode pads.
